(19) **Europäisches Patentamt**

**European Patent Office**

**Office européen des brevets**

(11) **EP 1 422 858 B1**

(12) **EUROPÄISCHE PATENTSCHRIFT**

| | |
|---|---|
| (45) Veröffentlichungstag und Bekanntmachung des Hinweises auf die Patenterteilung: **26.04.2006 Patentblatt 2006/17** | (51) Int Cl.: *H04L 1/00* (2006.01) *G06F 11/10* (2006.01) *H03M 13/09* (2006.01) |

(21) Anmeldenummer: **03021735.0**

(22) Anmeldetag: **25.09.2003**

(54) **Verfahren zur definierten Reduzierung der Restfehlerwahrscheinlichkeit bei der Übertragung von Daten**

Method for the defined reduction of the residual error probability in data transmission

Procédé de réduction définie de la probabilité d'erreurs résiduelles dans le cas de la transmission de données

(84) Benannte Vertragsstaaten:
**AT BE BG CH CY CZ DE DK EE ES FI FR GB GR HU IE IT LI LU MC NL PT RO SE SI SK TR**

(30) Priorität: **19.11.2002 DE 10253949**

(43) Veröffentlichungstag der Anmeldung:
**26.05.2004 Patentblatt 2004/22**

(73) Patentinhaber: **SIEMENS AKTIENGESELLSCHAFT**
**80333 München (DE)**

(72) Erfinder: **Merchant, Kamal**
**91058 Erlangen (DE)**

(56) Entgegenhaltungen:
**EP-A- 0 495 642**     **DE-A- 4 130 907**

**Beschreibung**

Die Erfindung betrifft ein Verfahren zur Bestimmung einer Restfehlerwahrscheinlichkeit bei der Übertragung von Daten

Zur sicheren Übertragung der Daten zwischen verschiedenen Komponenten eines sicherheitsrelevanten Systems, insbesondere Automatisierungssystems, wurden in der Vergangenheit proprietäre Lösungen, d. h. herstellerspezifische und separate Bussysteme angeboten und eingesetzt. Wegen der hohen Fehleranfälligkeit wird deshalb versucht die bewährten Bussysteme wie beispielsweise AS-I, PROFIBUS, CANopen, etc. durch zusätzliche Maßnahmen gegen Übertragungsfehler jeglicher Art abzusichern. Die wichtigsten Fehlerquellen sind z.B. Wiederholung, Verlust, falsche Abfolge oder Verzögerung der Daten sowie Verfälschung der Nutzdaten. Die Fehlerquellen der ersten Art lassen sich durch zusätzliche Softwaremaßnahmen relativ gut beseitigen.

Zur Aufdeckung von Verfälschung der Nutzdaten wird in der Regel bei der Datenübertragung das CRC-Verfahren eingesetzt. Dieses Verfahren deckt, je nach Aufwand, mit hoher Wahrscheinlichkeit die Datenverfälschung auf. Ein CRC-Test kann sowohl Hardware- als auch Software-gestützt abgearbeitet werden. Bei einem Datenblock von N Bits sind insgesamt $2^N-1$ verschiedene Fehlerfälle möglich. Bei einer Datenübertragung von beispielsweise 128 Byte (1 Byte entspricht 8 bit) beträgt N 1024 bits. Auch wenn die Fehleraufdeckungswahrscheinlichkeit sehr hoch gewählt werden kann, bleibt bei einem so hohen Datenaufkommen ein für sicherheitsrelevante Systeme nicht zu vernachlässigender Rest von Fehlerfällen, die unerkannt bleiben. Durch eine überproportionale und komplexe Erhöhung des Hardware- bzw. Softwareaufwandes kann die Restfehlerwahrscheinlichkeit bei der Anwendung des CRC-Verfahrens zwar weiter gesenkt werden, was jedoch mit einem enormen Kostenaufwand verbunden ist.

Zur Sicherung von Nutzdaten bei der Datenübertragung von einem Sender zu einem Empfänger wird insbesondere der Cyclic Redundancy Check, auch als CRC-Test bekannt, angewendet. Zur Durchführung solcher CRC-Tests werden linear rückgekoppelte Schieberegister auch Linear Feedback Shift Register, kurz LFSR genannt, eingesetzt. Ein n-Bit LFSR besteht aus n einzelnen Schieberegistern und kann bei geeigneter linearer Rückkopplung sämtliche $2^n-1$ möglichen Zustände mit Ausnahme des Zustands 0 = {0. .n X 0 . . .0} durchlaufen. Jedem LFSR wird ein charakteristisches Polynom $n^{ten}$ Grades zugeordnet. Die Rückkopplungen des LFSRs stellen die von null verschiedenen Koeffizienten dieses Polynoms dar. Ist das charakteristische Polynom irreduzibel, d.h. das Polynom lässt sich nicht mehr teilen, und primitiv, so liefert das dazugehörige LFSR eine maximale Folge von $2^n-1$ binären Daten, bevor eine Wiederholung stattfindet. Die lineare Rückkopplung eines LFSR's wird dabei insbesondere mittels eines EX-OR-Elements realisiert. Die Daten, die im Zuge des CRC-Verfahrens entsprechend codiert werden sollen, werden über einen weiteren Eingang des EX-OR-Elements bitweise Takt für Takt durch ein solches LFSR durchgeschoben. Bei einem Nutzdatenblock der Länge k und einem LFSR der Länge n werden insgesamt N=k+n Takte benötigt, um den kompletten Datenblock der Länge k durch das LFSR durchzuschieben. In dem LFSR bleibt dann ein n-bit breites Datum zurück. Das Durchschieben des Datenblocks durch ein solches LFSR ist somit vergleichbar mit der Division der Daten durch das dem LFSR zugeordnete charakteristische Polynom. Nach N Takten bleibt ein Rest, das n-bit breite Datum, im LFSR zurück. Dieser Rest ist eine signifikante Größe und charakteristisch für die Struktur des Datenblockes. Dieser Rest wird auch als Signatur oder Code des Datenblocks bezeichnet.

Durch eine solche Codierung bzw. Absicherung der zu sendenden Nutzdaten können Fehler bei der Datenübertragung erkannt und ggf. korrigiert werden, allerdings auf Kosten der Effizienz. So wird beispielsweise bei einem CRC-Test die n-Bit Signatur als Code oder Prüfzeichen an die k Nutzdaten angehängt und vom Sender zusätzlich mitgesendet. Die Signatur bildet dabei die sogenannte Redundanz. Auf der Empfängerseite wird derselbe CRC-Test mit den k Nutzdaten durchgeführt, worauf die beiden Signaturen auf Übereinstimmung verglichen werden. Um den Vergleich der Signaturen zu vereinfachen wird die zu sendende Signatur vor dem Senden in der Weise definiert verändert, dass die Bildung der Signatur über sämtliche N=k+n Bits eine Null ergibt. Ist die beim Empfänger gebildete Signatur in diesem Fall ungleich Null, so hat ein Fehler stattgefunden. Bei der Betrachtung der Bitfehler wird dabei zwischen den k Nutzdaten und der n-Bit Signatur bzw. der Redundanz nicht mehr unterschieden. Bei einem m-Bitfehler mit $m \leq N$ sind in der Regel Bits beispielsweise sowohl im Nutzdatenteil als auch im Signatur- bzw. Redundanzteil verfälscht.

Aus der EP-A-0 495 642 ist ein Fehlererkennungsverfahren bekannt, bei dem ein Fehlerprüfpolynom erzeugt wird, das in der Lage ist Fehler mit einer hohen Zuverlässigkeit zu detektieren.

Aus der DE 41 30 907 A ist eine Schaltungsanordnung zur Erzeugung zyklischer Codes bekannt, welche aus mehreren, in unterschiedlicher Weise über EXOR-Gatter rückgekoppelten Schieberegistern besteht. Hierdurch werden unterschiedliche Fehlersyndrome berechnet.

Der vorliegenden Erfindung liegt daher die Aufgabe zu Grunde, ein verbessertes Verfahren, einen Sender, einen Empfänger und ein System anzugeben, welche eine definierte Reduzierung der Restfehlerwahrscheinlichkeit bei der Übertragung von Daten erlauben.

Diese Aufgabe wird die Kombination der in den Ansprüchen 1, 11, 20 und 29 angegebenen Merkmale gelöst.

Durch die Anwendung des erfindungsgemäßen Verfahrens kann die Restfehlerwahrscheinlichkeit mit angemessenem Aufwand auf einen beliebig kleinen Wert reduziert werden.

Unter der Annahme, dass alle Fehlerfälle gleich wahrscheinlich sind, ist für N=n eine 100% Fehlererkennung möglich. Hierzu würde ein N-Bit breites LFSR benötigt. Der Aufwand dafür ist jedoch unverhältnismäßig hoch. Die Situation verbessert sich, wenn n kleiner als N wird. Damit ist immer n=N-k, mit k $\geq$ 0, wobei k die Nutzdateninformation in Bits darstellt. In diesem Falle können genau $2^k$ - 1 Fehlerfälle von insgesamt $2^N$ - 1 möglichen Fehlerfällen nicht erkannt werden. Bei einem Nutzdatenblock beispielsweise der Länge k=5 Bit, der beispielsweise mit einer 11-Bit Signatur (d.h. mittels eines LFSR der Länge 11 Bit bzw. n=11) abgesichert wird, ergibt sich also ein zu sendender Gesamtdatenblock der Länge N=16 Bit, bei dem 31 Fehlerfälle von insgesamt 65535 möglichen Fehlerfällen unerkannt bleiben. Da in der praktischen Anwendung N bis zu 1024 und mehr betragen kann und die Länge der Signaturen n, d.h. der linear rückgekoppelten Schieberegister (LFSR), je nach Anforderung zwischen 8 und 32 Bits beträgt, bleibt für fehlersichere Systeme ein nicht zu tolerierendes Restrisiko übrig, obwohl bereits mit einem 16-Bit LFSR eine Fehlererkennung von größer als 99,998% erreicht werden kann.

Nach einer besonders vorteilhaften Ausführungsform der Erfindung besteht ein Code aus Signaturbits. Darüber hinaus bestehen die zu übertragenden Daten aus Nutzdatenbits und/oder Signaturbits.

Nach einer weiteren überaus vorteilhaften Ausführungsform der Erfindung erfolgt das Generieren der Codes mittels Codiervorschriften und wobei zur Bestimmung der Hamming-Distanz der Codiervorschriften und/oder der generierten Codes die Gesamtheit aller bei der jeweiligen Datenübertragung unerkannten Fehler aus einer Anzahl linear unabhängiger Datenblöcke gebildet wird, wobei die Anzahl der linear unabhängigen Datenblöcke jeweils der Anzahl der Nutzdatenbits entspricht.

Ein Fehlerfall kann dann nicht erkannt werden, wenn der entsprechende Fehlerfall maskiert wird. Bei einem n-Bit LFSR entspricht das erste Bit der Rückkopplung dem letzten Schieberegister und das letzte Bit der Rückkopplung dem ersten Schieberegister des LFSRs. Die einfachste Rückkopplung entsteht, wenn nur das $n^{te}$, also das letzte Schieberegister rückgekoppelt wird. Dabei muss das $n^{te}$, d.h. das letzte Schieberegister des LFSR stets rückgekoppelt werden, da sich das LFSR sonst auf m Stellen verkürzt, wobei m die höchste Stelle des LFSR symbolisiert, die rückgekoppelt wird. Jedes rückgekoppelte Bit wird mit einer eins markiert, d.h. das erste Bit einer beliebigen Rückkopplung $R_k$ ist stets eine eins. Die restlichen (n-1) Bits der Rückkopplung des LFSR können alle möglichen Kombinationen von 0 und 1 annehmen. Mit einem n-Bit LFSR können somit maximal $2^{(n-1)}$ verschiedene Rückkopplungen realisiert werden.

Wird ein fehlerhaftes Bit des Nutzdatenblocks durch das LFSR eines Empfängers geschoben, kommt es nach n Takten am letzten Schieberegister des LFSR an. Wenn gerade zu diesem Zeitpunkt ein weiteres fehlerhaftes Bit in das erste Schieberegister des LFSR geschoben wird, so wird dieser Fehler maskiert und die Signatur ab diesem Zeitpunkt ist identisch für beide Datenblöcke. Ein solcher Fehler kann mit der eingangs gewählten Rückkopplung $R_k$ nicht erkannt werden. d.h, dass zwei Fehler im Abstand von n Bits den Fehler für die gewählte Rückkopplung $R_k$ maskieren. Bei einem Nutzdatenblock der Länge k gibt es somit k verschiedene Datenblöcke, bei denen die Fehler maskiert werden. Bei dem ersten Datenblock sind das erste und $(n + 1)^{te}$ Bit fehlerhaft. Beim $k^{ten}$ Datenblock sind analog das $k^{te}$ und $(n + k)^{te}$ Bit fehlerhaft. Eine Eins in den fehlerhaften Datenblöcken markiert dabei diejenige Stelle, die fehlerhaft sein kann, ohne dass der CRC-Test diesen Fehler aufdecken kann. Der Null-Vektor (alle Bits gleich null) bildet dabei den Bezugspunkt. Durch eine EX-OR-Verknüpfung eines beliebigen Datenblocks mit den fehlerhaften Datenblöcken bekommt man die zu diesem Datenblock zugehörigen k Fehlerfälle, die von CRC-Tests nicht erkannt werden können. Diese k fehlerhaften Datenblöcke bilden die Grundelemente der Menge aller unerkannten Fehler und haben eine eindeutige Zuordnung zur Rückkopplung aus der sie abgeleitet werden.

Die Menge aller unerkannten Fehler bildet eine Gruppe. Fundamentale Eigenschaft einer Gruppe ist es, dass, gehören zwei Elemente A und B zu einer Gruppe, dann gehört auch das Element C mit:

$$C = A + B$$

zu dieser Gruppe. Es handelt sich dabei um eine Modulo 2 Addition. Durch gruppenweise Addition von k Grundelementen jeweils einer Gruppe von je 2 bis k Elementen lassen sich somit sämtliche $2^k$-1 Elemente der Gruppe gewinnen. Damit alle $2^k$-1 Elemente verschieden und ungleich null sind, müssen die k Grundelemente linear unabhängig sein. Betrachtet man die k Grundelemente als N-dimensionale Vektoren, bilden die einzelnen Datenbits dann die N binären Komponenten dieses Vektors. Dabei gilt, dass die k Vektoren $A_i$ mit i=1 bis k dann und nur dann linear unabhängig sind, wenn aus der Bedingung

$$\sum_{i=1}^{k} \alpha_i A_i = 0$$

unmittelbar folgt, dass alle $\alpha_i$ gleich null sind. Dies ist insbesondere auchgültig, unabhängig von den gewählten Rückkopplungen $R_k$.

Bei der Sicherung eines Datenblocks der Länge N mit einer n-Bit Signatur (mit n=N-k) existieren somit $2^k-1$ Kombinationen von Fehlerfällen, die nicht mehr als fehlerhaft erkannt werden können. Zusammen mit dem Null-Element bilden sie eine Gruppe, die als "Fehlergruppe" bezeichnet wird. Zu jedem Datenblock gehören maximal $2^{(n-1)}$ verschiedene Fehlergruppen, abhängig von der gewählten Rückkopplung $R_k$.

Die Sicherheit der übertragenen Nachricht hängt im wesentlichen von der Güte des Übertragungsmediums sowie den Maßnahmen zur Fehlererkennung durch geeignete Codierung ab. Bei einem schlechten Übertragungsmedium wird die gesendete Nachricht mit einer höheren Wahrscheinlichkeit verfälscht. Die empfangenen Bits kommen zum Teil invertiert an. Die Gl. (1) definiert die Bitfehlerrate p. Je schlechter ein Übertragungsmedium ist, um so höher ist die Bitfehlerrate p und um so häufiger wird die Nachricht verfälscht.

$$p = \frac{\text{Anzahl der fehlerhaft empfangenen Bits}}{\text{Gesamtzahl der gesendeten Bits}} \quad (1)$$

Neben der Bitfehlerrate p gibt es eine Wahrscheinlichkeit q=1-p dafür, dass ein Bit unverfälscht, also korrekt empfangen wird. Bei einem Datenblock der Länge N Bit gibt es insgesamt $2^N-1$ Fehlerkombinationen. Jeder dieser Fälle hat eine definierte Wahrscheinlichkeit, mit der das Ereignis eintrifft. Die Wahrscheinlichkeit, dass in der empfangenen Nachricht m Bits verfälscht und N-m Bits korrekt sind, beträgt $p^m q^{(N-m)}$. Die Summe aller Wahrscheinlichkeiten für alle Fehlerfälle wird durch die G1. (2) wiedergegeben und beträgt 1, da hierin sämtliche Kombinationen enthalten sind.

$$\sum_{m=0}^{N} \binom{N}{m} \times p^m \times q^{N-m} = 1 \quad (2)$$

Die Koeffizienten $\binom{N}{m}$ in der G1. (2) sind dabei die Binomialkoeffizienten und stellen die Häufigkeit des Vorkommens von m-Bitfehlern dar. Bei gegenwärtigen Übertragungssystemen liegt die Bitfehlerrate p in der Regel in einer Größenordnung von $p \leq 10^{-3}$.

Die Restfehlerwahrscheinlichkeit R(p) wird durch die G1. (3) bestimmt. In der G1. (3) wurden lediglich die Binomialkoeffizienten durch die Häufigkeit H(m) der m-Bitfehler, die der verwendete Code nicht mehr erkennen kann, ersetzt. d stellt hier die Hamming-Distanz des angewendeten Codes dar. Die Hamming-Distanz zwischen zwei gültigen Codewörter wird durch die Anzahl der Bits, in denen die Codewörter sich unterscheiden, gegeben. Bei einem Code mit der Hamming-Distanz von mindestens d werden d-1 Bitfehler sicher erkannt. Daher tragen die Terme in der Gl. (3) erst ab m=d zur Restfehlerwahrscheinlichkeit bei.

$$R(p) = \sum_{m=d}^{N} H(m) \times p^m \times q^{N-m} \quad (3)$$

Die Norm (DIN 19 244) erwartet je nach geforderter Integritäts- bzw. Sicherheitsklasse, dass die Restfehlerwahrscheinlichkeit einen bestimmten, vorgegebenen Wert nicht überschreitet.

Bei einer Datenübertragung stehen folglich folgende Erwartungen im Vordergrund:

- Erkennung von möglichst vielen Fehlern,

- Erkennung von Mehrbitfehlern mit einem breiten Spektrum von Bitfehlerzahlen,

- Unterdrückung der Restfehlerwahrscheinlichkeit.

Der erste Punkt kann durch die Wahl einer angemessenen Länge der Signatur (Redundanz) entsprechend günstig beeinflusst werden, bei der Systemanforderungen, Wirtschaftlichkeit und Systemperformance gegeneinander abgewogen werden müssen. Die nächsten zwei Anforderungen können durch die Erhöhung der Hamming-Distanz des verwendeten Codes erfüllt werden, denn dann beginnt die Summenbildung in der G1. 3 mit einer höheren Potenz. Wenn die Hamming-Distanz um einen Punkt vergrößert wird, so verkleinert sich die Restfehlerwahrscheinlichkeit um drei Zehnerpotenzen ($p = 10^{-3}$ als schlechtes Medium). Die Hamming-Distanz ist aber abhängig von der Blocklänge N, die übertragen wird.

Beispielhaft soll ein n-Bit LFSR mit der maximalen Rückkopplung betrachtet werden, bei der jedes Bit des LFSR rückgekoppelt wird. Ist k=1 und N=n+1, so besteht die Fehlergruppe aus einem einzigen Fehlerfall mit n+1 Einsen, der nicht mehr erkannt wird. Die Hamming-Distanz beträgt hier n+1 und dieser Code ist in der Lage alle Fehlerfälle bis zu n-Bitfehler zu erkennen. Wird k nur um ein einziges Bit erhöht, stellt sich folgende Situation dar. Mit k=2 gibt es zwei linear unabhängige Grundelemente, bestehend aus n+1 Einsen und einer Null. Bei dem ersten Grundelement steht die Null an der ersten Stelle und bei dem zweiten Grundelement an der letzten Stelle. Ein drittes Element wird durch die Addition der beiden Grundelemente gebildet und enthält genau zwei Einsen. Die Hamming-Distanz des Codes reduziert sich von n+1 auf 2. Dieses Beispiel verdeutlicht die Schwierigkeit der Wahl einer günstigen Rückkopplung, wobei es darüber hinaus insgesamt $2^{n-1}$ mögliche Rückkopplungen gibt, aus denen eine ausgewählt werden muss.

Zur Auswahl günstiger Rückkopplungen eignen sich primitive Polynome $n^{ten}$ Grades, die mindestens eine Hamming-Distanz von 3 bis zu einer Blocklänge von $N=2^{n}-1$ aufweisen. Diese werden auch in bestehenden Systemen bevorzugt eingesetzt. Darüber hinaus eignen sich ebenfalls sogenannte CCITT Polynome. Ein CCITT-Polynom ist ein primitives Polynom $n^{ten}$ Grades, welches durch (x+1) teilbar ist und nach erfolgter Teilung wiederum ein primitives Polynom ergibt. Solche Polynome weisen mindestens eine Hamming-Distanz von 4 bis zu einer Blocklänge von $N=2^{(n-1)}-1$ auf und erkennen zusätzlich alle ungeraden Anzahlen der Bitfehler. Ein CCITT-Polynom $n^{ten}$ Grades lässt sich beispielsweise durch Multiplikation eines primitiven Polynoms $(n-1)^{ten}$ Grades mit (x+1) sehr einfach generieren.

Die mit solchen Polynomen erz.ielbare Restfehlerwahrscheinlichkeit erfüllt allerdings größtenteils nicht die Anforderungen eines sicherheitsrelevanten Systems mit einer höheren Anforderungsklasse bzw. einem höheren Safety Integrity Level, kurz SIL-Stufe genannt. Eine weitere Verbesserung der Restfehlerwahrscheinlichkeit kann nur durch eine Erhöhung der Hamming-Distanz realisiert werden.

Die Anwendung des erfindungsgemäßen Verfahrens erhöht mit geringem Aufwand signifikant die Hamming-Distanz und reduziert damit die Restfehlerwahrscheinlichkeit für die Übertragung von Daten je nach Anforderung des Systems auf beliebig kleine Werte. Hierzu wird ein konventioneller CRC-Test mit einem zweiten unabhängigen CRC-Test kombiniert.

Nach einer besonders vorteilhaften Ausführungsform der Erfindung weist der Sender als Mittel zum Codieren der Nutzdaten wenigstens ein erstes und ein zweites linear rückgekoppeltes Schieberegister auf und der Empfänger weist als Mittel zum Codieren der Nutzdaten wenigstens ein drittes und ein viertes linear rückgekoppeltes Schieberegister auf. Darüber hinaus verwenden das erste und das dritte linear rückgekoppelte Schieberegister jeweils die gleiche Codiervorschrift und das zweite und das vierte linear rückgekoppelte Schieberegister jeweils die gleiche Codiervorschrift, wobei die jeweilige Codiervorschrift durch eine entsprechende lineare Rückkopplung der jeweiligen Schieberegister realisiert ist. Zusätzlich verwenden das erste linear rückgekoppelte Schieberegister und das zweite linear rückgekoppelte Schieberegister unterschiedliche Codiervorschriften. Dadurch ist es möglich, dass die zu sendenden Nutzdaten durch zwei völlig unterschiedliche Rückkopplungen der linear rückgekoppelten Schieberegister, der LFSR's, also durch erhöhte Redundanz abgesichert werden können. Durch die beiden unterschiedlichen Rückkopplungen, die in dem ersten und zweiten LFSR des Senders sowie entsprechend in dem dritten und vierten LFSR des Empfängers verwendet werden und die die unterschiedlichen Codierungsvorschriften symbolisieren, werden für die selben Nutzdaten vom Sender jeweils zwei unterschiedliche Signaturen generiert, die dann in einem Datenblock der Länge N=k+n1+n2 mit k Informationsbits, n1-Bitsignatur des ersten LFSR und n2-Bitsignatur des zweiten LFSR, an den Empfänger gesendet werden. Die Nutzdaten werden mit zweifacher Redundanz abgesichert, wobei die Nutzdaten nur einmal gesendet werden. Dadurch können einerseits die Eigenschaften von zwei völlig unterschiedlichen Codes bei gleichzeitiger Erhöhung der Redundanz kombiniert werden und außerdem ist die Performance durch die Übertragung eines kleineren Datenblocks der Länge N1=k+n1+n2 gegenüber der Übertragung von zwei Datenblöcken N1= k+n1 und N2=k+n2 von zwei getrennten CRC-Tests mit der Gesamtlänge N1+N2 vergleichsweise besser.

Nach einer weiteren besonders vorteilhaften Ausführungsform der Erfindung weist der Code, der durch die zweite Codiervorschrift generiert wird, eine größere oder kleinere Hamming-Distanz auf als der Code, der durch die erste Codiervorschrift generiert wird. Desweiteren weist der Code, der durch die zweite Codiervorschrift generiert wird, eine größere oder kleinere Anzahl an Signaturbits auf als der Code, der durch die erste Codiervorschrift generiert wird. Darüber hinaus ist die Hamming-Distanz des erzeugten Codes, der in Kombination verwendeten ersten und zweiten Codiervorschrift größer als die größere der beiden Hamming-Distanzen, der durch die erste oder zweite Codiervorschrift erzeugten Codes, wenn die Anzahl der zu übertragenden Nutzdatenbits kleiner oder gleich der geringsten Anzahl der jeweils zugehörigen Signaturbits, also kleiner oder gleich der Anzahl der kleineren der zugehörigen Signaturbits n1 bzw. n2 ist. Die auf der Sendeseite durch das erste LFSR mit einer ersten Rückkopplung erzeugte Signatur und die durch das zweite LFSR mit einer zweiten Rückkopplung erzeugte Signatur weisen bei geeigneter Auswahl der Rückkopplungen unterschiedliche Hamming-Distanzen auf. Ist beispielsweise die Hamming-Distanz HD1 des durch die erste Codiervorschrift erzeugten Codes kleiner als die Hamming-Distanz HD2 des durch die zweite Codiervorschrift erzeugten Codes und ist die Anzahl der zu übertragenden Nutzdatenbits k kleiner oder gleich der Anzahl der kleineren der zugehörigen Signaturbits n1 bzw. n2, so ist die Hamming-Distanz HD12 des durch die kombinierte Anwendung der beiden Codierungsvorschriften gemäß des erfindungsgemäßen Verfahrens generierten Codes immer um mindestens eins größer als die Hammingdistanz HD2. Dasselbe gilt selbstverständlich analog zum umgekehrten Fall, falls HD1 größer als HD2 ist. Dies bedeutet, dass sich die Restfehlerwahrscheinlichkeit entsprechend des Unterschieds der Hamming-Distanzen HD12 zu HD2 bzw. zu HD1 reduziert. Je größer der Unterschied ist, desto stärker reduziert sich auch die Restfehlerwahrscheinlichkeit. Beträgt der Unterschied der Hamming-Distanz HD12 zur Hamming-Distanz HDX (mit X=1 oder 2) beispielsweise 5, so reduziert sich die Restfehlerwahrscheinlichkeit um einen Faktor von ungefähr der Größe $10^{-15}$ im Vergleich zur separaten Anwendung von einer der beiden gewählten Rückkopplungen bzw. Codierungsvorschriften mit den Hamming-Distanzen HDX in zwei voneinander unabhängigen CRC-Tests.

Im Weiteren werden bevorzugte Ausführungsbeispiele der Erfindung mit Bezugnahme auf die Zeichnungen näher erläutert. Es zeigen:

FIG 1     ein Blockschaltbild eines beispielhaften Übertragungssystems zum Ablauf des erfindungsgemäßen Verfahrens,

FIG 2     ein erstes beispielhaftes Flussdiagramm des erfindungsgemäßen Verfahrens,

FIG 3     ein zweites beispielhaftes Flussdiagramm des erfindungsgemäßen Verfahrens,

FIG 4     eine Tabelle zur Häufigkeitsverteilung der Hamming-Distanzen für Datenblöcke mit N=16 und n=11 und

FIG 5     eine Tabelle zur Verteilung der unerkannten Fehlerfälle für m-Bittupel in Abhängigkeit der Anzahl der Bitfehler für das CCITT Polynom 10

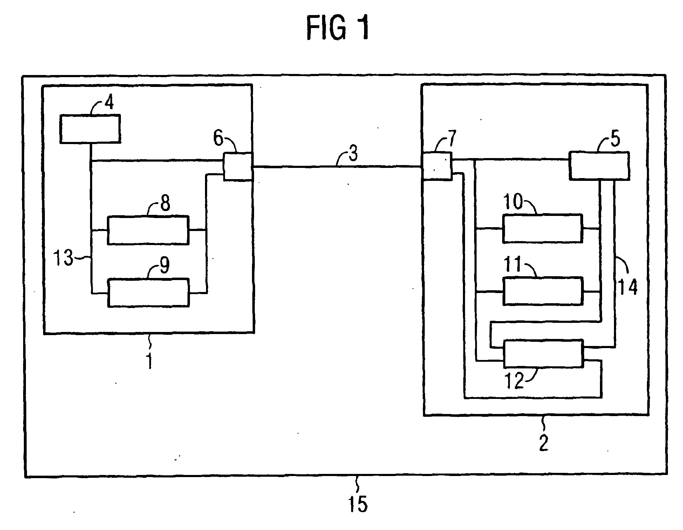

FIG 1 zeigt ein Blockschaltbild eines beispielhaften Übertragungssystems zum Ablauf des erfindungsgemäßen Verfahrens. Reicht die Hamming-Distanz beispielsweise eines konventionellen CRC-Tests zur Einhaltung einer höheren Anforderungsklasse oder SIL-Stufe (Safety Integrity Level) für sicherheitsrelevante Systeme nicht aus, lässt sich diese mittels des erfindungsgemäßen Verfahrens vergrößern. Hierzu wird, wie in der FIG 1 dargestellt der konventionelle CRC-Test mit einem zweiten CRC-Test erweitert. Es soll ein Nutzdatenblock mit k Informationsbits gesendet und dieser mit einer n-Bitsignatur abgesichert werden. Nach konventionellem CRC-Test beträgt die Länge eines zu sendenden Datenblocks N=k+n Bit.

Das Übertragungssystem 15 aus der FIG 1 besteht dabei beispielsweise aus einem Sender 1 und einem Empfänger 2, die über die Übertragungsstrecke 3 miteinander verbunden sind. Selbstverständlich sind auch andere Systeme denkbar und möglich, die eine beliebige Anzahl von Teilnehmern, insbesondere Sender und Empfänger aufweisen. Die Übertragungsstrecke 3, die insbesondere Daten in beide Richtungen übertragen kann, ist auf Seiten des Senders 1 mit einer Sende- und Empfangseinheit 6 verbunden sowie auf Seiten des Empfängers 2 mit einer Sende- und Empfangseinheit 7. Sender 1 und Empfänger 2 sind beispielsweise, je nach Bedarf als Rechner, Personal Computer, Workstation, Notebook, etc., das System ist beispielsweise als Automatisierungssystem ausgebildet. Als Übertragungsstrecke 3 ist ein beliebiges Netzwerk, beispielsweise Ethernet, oder beliebige andere drahtgebundene Übertragungsstrecken bzw. Netzwerke, aber auch drahtlose Übertragungsstrecken bzw. Netzwerke, beispielsweise Funk LAN, möglich. Der Sender 1 weist beispielsweise wenigstens einen Speicher 4 sowie ein erstes und zweites Schieberegister (LFSR) 8, 9 auf. Die beiden Schieberegister können die gleiche Länge n = n1 = n2 aufweisen, sie können selbstverständlich aber auch unterschiedlicher Länge sein, n1 > n2, bzw. n2 > n1. Die einzelnen Elemente des Senders 1 sind jeweils mittels interner Verbindungsstrecken 13 untereinander verbunden. Dabei enthält beispielsweise der Speicher 4 des Senders 1 Nutzdaten, die mittels der Übertragungsstrecke 3 an den Empfänger 2 übertragen werden sollen. Der Empfänger 2 weist u.a. einen Speicher 5, ein drittes und viertes Schieberegister 10, 11 sowie eine Auswerteeinheit 12 auf. Die einzelnen Elemente des Empfängers 2 sind jeweils mittels interner Verbindungsstrecken 14 untereinander verbunden. So werden beispielsweise die im Speicher 4 zur Übertragung vorgesehenen Nutzdaten zunächst über die internen Verbindungsstrecken 13 an die Sende- und Empfangseinheit 6 des Senders weitergeleitet, die die Nutzdaten über die Übertragungsstrecke 3 an die Sende- und Empfangseinheit 7 des Empfängers 2 übermittelt, welche die Nutzdaten beispielsweise im Speicher 5 des Empfängers 2 speichert. Parallel dazu werden die Nutzdaten innerhalb des Senders 1 an das erste Schieberegister 8 und an das zweite Schieberegister 9 weitergeleitet. In den beiden Schieberegistern 8 und 9 werden die entsprechenden Nutzdaten codiert, wodurch jeweils eine sogenannte Signatur entsteht. Da die beiden Schieberegister 8 und 9 jeweils unterschiedliche, voneinander linear unabhängige Rückkopplungen aufweisen, also insbesondere unterschiedliche Codiervorschriften verwenden, entstehen jeweils auch zwei voneinander unabhängige Signaturen zu dem gleichen Satz Nutzdaten. Selbstverständlich ist es auch möglich, dass die LFSR's 8 und 9 die gleichen Rückkopplungen aufweisen und folglich die gleichen Codiervorschriften verwenden, jedoch ist der Nutzen in der Regel vergleichbar gering im Gegensatz zur Verwendung unterschiedlicher Rückkopplungen bzw. Codiervorschriften.

Das dritte Schieberegister 10 des Empfängers 2 weist dabei die gleiche Rückkopplung auf wie das erste Schieberegister 8 des Senders 1 und das vierte Schieberegister 10 des Empfängers 2 weist die gleiche Rückkopplung auf wie das zweite Schieberegister 8 des Senders 1. Die zusammengehörigen Schieberegister des Senders 1 und des Empfängers 2 (LFSR 8 und LFSR 10, bzw. LFSR 9 und LFSR 11) verwenden also jeweils paarweise insbesondere die gleiche Codiervorschrift. Auf der Empfängerseite werden die Nutzdaten von der Sende- und Empfangseinheit 7 beispielsweise im Speicher 5 zwischengespeichert, von wo aus sie vom Empfänger 2 bei korrekter Übermittlung weiterverarbeitet werden können. Parallel dazu werden die Nutzdaten mittels der internen Verbindungsstrecken 14 beispielsweise an das dritte und vierte Schieberegister 10 und 11 weitergeleitet, worin die empfangenen Nutzdaten ebenfalls entsprechend des Senders 1 mit den jeweils unterschiedlichen Codiervorschriften codiert werden. Dadurch entstehen ebenfalls zwei voneinander unabhängige Signaturen. Die im Sender 1 vom Schieberegister 8 sowie vom Schieberegister 9 generierten Signaturen werden ebenfalls über die Sende- und Empfangseinheit 6 mittels der Übertragungsstrecke 3 an die Sende- und Empfangseinheit 7 des Empfängers 2 übertragen, welche sie beispielsweise in die Auswerteeinheit 12 weiterleitet. Darüber hinaus werden die von den Schieberegistern 10 und 11 des Empfängers 2 generierten Signaturen ebenfalls in die Auswerteeinheit 12 weitergeleitet, worin die Signatur des ersten Schieberegisters 8 des Senders 1 und die Signatur des dritten Schieberegisters 10 des Empfängers 2 sowie die Signatur des zweiten Schieberegisters 9 mit der Signatur des vierten Schieberegisters 11 des Empfängers auf Übereinstimmung verglichen werden. Ist dies der Fall, können die Daten, die im Speicher 5 des Empfängers 2 zwischengespeichert wurden, vom Empfänger 2 weiterverarbeitet werden. Ist keine Übereinstimmung vorhanden, so wird beispielsweise von der Auswerteeinheit 12 des Empfängers 2 über die Sende- und Empfangseinheit 7 eine entsprechende Rückmeldung an den Sender 1 getätigt, dass ein Fehler bei der Datenübertragung aufgetreten ist, wodurch beispielsweise ein erneuter Sendevorgang ausgelöst werden kann.

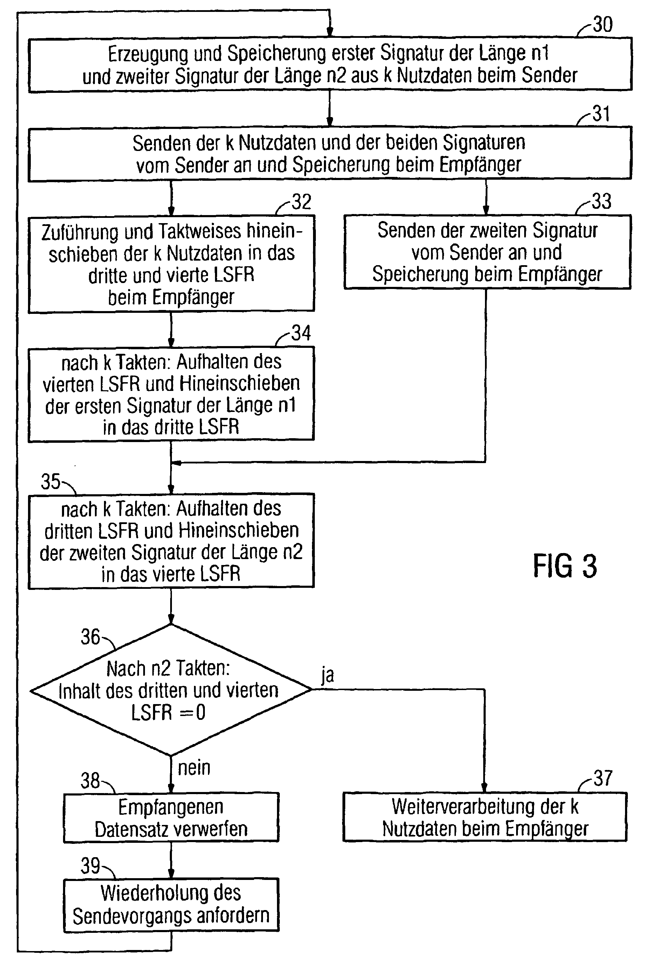

Ein Vergleich der jeweiligen Signaturen und damit die Auswerteeinheit 12 ist dann überflüssig, wenn der gesamte übertragene Datensatz, also Nutzdaten und die beiden beim Sender 1 generierten Signaturen, in geeigneter Weise von den LFSR's 10 und 11 des Empfängers 2 codiert werden. In diesem Fall muss bei korrekter Datenübertragung in den Schieberegistern 10 und 11 des Empfängers 2 nach der Codierung jeweils die Signatur Null stehen. Ist die Signatur ungleich Null, ist ein Fehler bei der Datenübertragung aufgetreten und die Empfangsdaten werden verworfen. Eine Detailbeschreibung erfolgt bei der Beschreibung der FIG. 3.

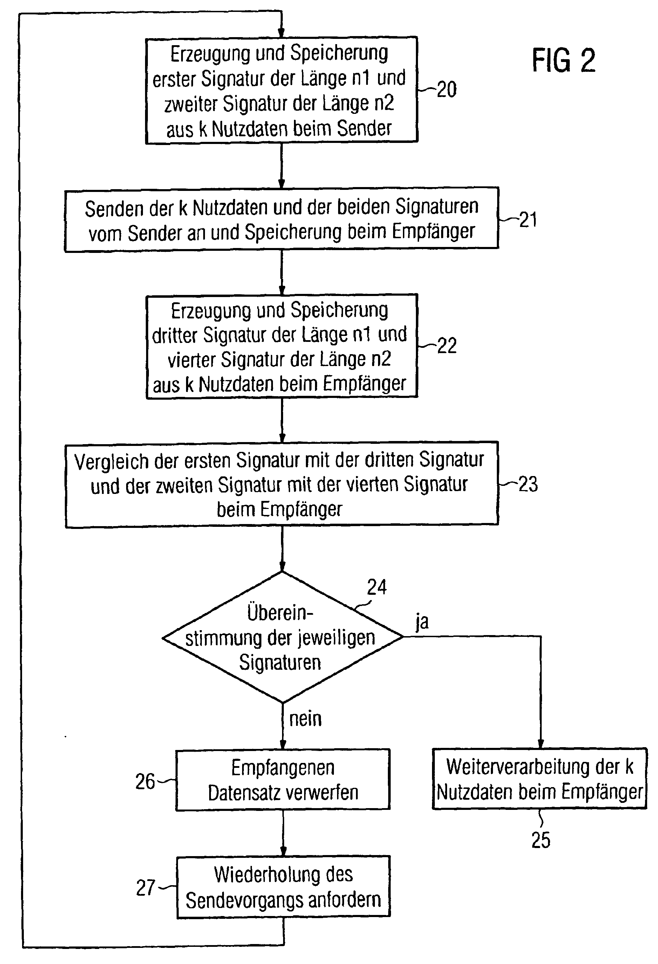

FIG 2 zeigt ein erstes beispielhaftes Flussdiagramm des erfindungsgemäßen Verfahrens. Im Schritt 20 wird zunächst beim Sender 1 vom ersten Schieberegister (LFSR) 8, welches eine erste Rückkopplung aufweist, aus den k Nutzdaten eine erste n-Bit-Signatur mit der Länge n1 und der Hamming-Distanz HD1 erzeugt und gespeichert. Parallel dazu wird ebenfalls beim Sender 1 vom zweiten LFSR 9, welches eine zweite Rückkopplung aufweist, aus den k Nutzdaten eine zweite n-Bit-Signatur mit der Länge n2 und der Hamming-Distanz HD2 erzeugt und gespeichert. Die Signaturen n1 und n2 können dabei unterschiedliche Bitlänge, sie können insbesondere aber auch die gleiche Bitlänge aufweisen. Für den Rest des vorliegenden Dokuments soll deshalb gelten, dass n das Minimum aus den beiden Signaturen n1 und n2 darstellt, also $n=\min(n1,n2)$.

Im Schritt 21 werden die k Nutzdaten sowie die beiden Signaturen n1 und n2 vom Sender 1 an den Empfänger 2 gesendet und dort zwischengespeichert. Insgesamt wird also ein Datenblock der Länge $N=k+n1+n2$ Bit vom Sender 1 an den Empfänger 2 übertragen.

Beim Empfänger 2 werden im Schritt 22 die k Nutzdatenbits parallel den beiden LFSR's 10 und 11 zugeführt. Vom dritten Schieberegister (LFSR) 10, welches die erste Rückkopplung aufweist, wird aus den k Nutzdaten eine dritte n-Bit-Signatur mit der Länge n1 erzeugt und gespeichert. Parallel dazu wird vom vierten LFSR 11, welches die zweite Rückkopplung aufweist, aus den k Nutzdaten eine vierte n-Bit-Signatur mit der Länge n2 erzeugt und gespeichert.

Im Schritt 23 wird beispielsweise in der Auswerteeinheit 12 des Empfängers 2 die erste mit der dritten Signatur und die zweite mit der vierten Signatur auf Übereinstimmung verglichen.

Ist im Schritt 24 eine paarweise Übereinstimmung der Signaturen festgestellt worden, ist bei der Datenübertragung kein Fehler aufgetreten und im Schritt 25 können die vom Empfänger 2 empfangenen k Nutzdaten weiterverarbeitet werden.

Ist im Schritt 24 keine paarweise Übereinstimmung der Signaturen festgestellt worden, ist bei der Datenübertragung ein Fehler aufgetreten und im Schritt 26 werden die vom Empfänger 2 empfangenen k Nutzdaten verworfen, worauf im Schritt 27 vom Sender 1 beispielsweise eine Wiederholung des Sendevorgangs angefordert wird.

FIG 3 zeigt ein zweites beispielhaftes Flussdiagramm des erfindungsgemäßen Verfahrens. Im Schritt 30 wird zunächst beim Sender 1 vom ersten Schieberegister (LFSR) 8, welches eine erste Rückkopplung aufweist, aus den k Nutzdaten eine erste n-Bit-Signatur mit der Länge n1 und der Hamming-Distanz HD1 erzeugt und gespeichert. Parallel dazu wird ebenfalls beim Sender 1 vom zweiten LFSR 9, welches eine zweite Rückkopplung aufweist, aus den k Nutzdaten eine zweite n-Bit-Signatur mit der Länge n2 und der Hamming-Distanz HD2 erzeugt und gespeichert. Die Signaturen n1 und n2 können dabei wiederum unterschiedliche Bitlänge, sie können insbesondere aber auch die gleiche Bitlänge aufweisen.

Im Schritt 31 werden vom Sender 1 die k Nutzdaten sowie die erste Signatur n1 an den Empfänger 2 gesendet und dort zwischengespeichert. Anschließend werden beim Empfänger 2 im Schritt 32 die k Nutzdatenbits parallel den beiden LFSR's 10 und 11 zugeführt und taktweise hineingeschoben.

Parallel dazu wird im Schritt 33 vom Sender 1 die zweite Signatur n2 separat an den Empfänger 2 gesendet und dort gespeichert. Insgesamt ist also ein Datenblock der Länge N=k+n1+n2 Bit vom Sender 1 an den Empfänger 2 übertragen worden.

Nach k Takten wird beim Empfänger 2 im Schritt 34 das vierte LFSR 11 angehalten und die erste Signatur n1 in das dritte LFSR 10 geschoben. Das dritte Schieberegister (LFSR) 10, welches die erste Rückkopplung aufweist, codiert damit die k Nutzdaten und die erste Signatur n1. Ist bei der Datenübertragung kein Fehler aufgetreten, muss nach weiteren n1 Takten, also insgesamt nach k+n1 Takten im LFSR 10 die Signatur Null stehen. Ist dies nicht der Fall, so ist bei der Datenübertragung ein Fehler aufgetreten. In diesem Fall kann selbstverständlich der Codierungsvorgang abgebrochen und die empfangenen Daten entsprechend Schritt 38 verworfen werden.

Nach weiteren n1 Takten wird beim Empfänger 2 im Schritt 35 das dritte LFSR 10 angehalten und die zweite Signatur n2 in das vierte LFSR 11 geschoben. Das vierte Schieberegister (LFSR) 11, welches die zweite Rückkopplung aufweist, codiert damit die k Nutzdaten und die zweite Signatur n2. Ist bei der Datenübertragung kein Fehler aufgetreten, muss nach weiteren n2 Takten, also insgesamt nach k+n2 Takten im LFSR 11 die Signatur Null stehen. Ist dies nicht der Fall, so ist bei der Datenübertragung ein Fehler aufgetreten.

Nach insgesamt k+n1+n2 Takten ist beim Empfänger 2 die Codierung des gesamten übertragenen Datenblocks abgeschlossen und im Schritt 36 wird überprüft, ob in beiden Schieberegistern 10 und 11 jeweils die Signatur Null steht.

Ist im Schritt 36 festgestellt worden, dass in beiden Schieberegistern 10 und 11 jeweils die Signatur Null steht, ist bei der Datenübertragung kein Fehler aufgetreten und im Schritt 37 können die vom Empfänger 2 empfangenen k Nutzdaten weiterverarbeitet werden.

Ist im Schritt 36 festgestellt worden, dass in beiden Schieberegistern 10 und 11 nicht jeweils die Signatur Null steht, ist bei der Datenübertragung ein Fehler aufgetreten und im Schritt 38 werden die vom Empfänger 2 empfangenen k Nutzdaten verworfen, worauf im Schritt 39 vom Sender 1 beispielsweise eine Wiederholung des Sendevorgangs angefordert wird. Selbstverständlich sind auch andere Reaktionen denkbar und möglich.

Die Nutzdaten werden, wie in den Beschreibungen der Figuren 1-3 offenbart, mit zweifacher Redundanz abgesichert, wobei die Nutzdaten nur einmal gesendet werden. Darüber hinaus ergibt sich für den erweiterten Datenblock der Länge k+n1+n2 Bit eine größere Hamming-Distanz HD12. Durch Anwendung des erfindungsgemäßen Verfahren können einerseits die Eigenschaften von zwei völlig unterschiedlichen Codes bei gleichzeitiger Erhöhung der Redundanz kombiniert werden und außerdem ist die Performance durch die Übertragung eines kleineren Datenblocks der Länge N1=k+n1+n2 gegenüber der Übertragung von zwei Datenblöcken N1= k+n1 und N2=k+n2 von zwei getrennten CRC-Tests mit der Gesamtlänge N1+N2 vergleichsweise besser. Gleichzeitig ergibt sich insbesondere für kleine k eine enorme Verbesserung der Restfehlerwahrscheinlichkeit durch überproportionale Erhöhung der Hamming-Distanz. Gerade für Sicherheitssysteme, bei denen wenige Bytes Übertragen werden, liefert das Verfahren eine bevorzugte Möglichkeit zur Verbesserung und exakten Bestimmung der Restfehlerwahrscheinlichkeit.

Im folgenden wird mit HD die Hamming-Distanz des Codes bzw. der gewählten Rückkopplung $R_k$ und mit Hd die Hamming-Distanz eines beliebigen Fehlerfalles bezeichnet. Zur Bestimmung der Hamming-Distanz HD12 des anhand der FIG 2 bzw. 3 beschriebenen erfindungsgemäßen Verfahrens sind die folgenden Schritte notwendig. Die Hamming-Distanz Hd eines Fehlerfalles für den konventionellen CRC-Test besteht aus zwei Teilen. Die k Informationsbits bilden dabei den ersten Teil, der als Datum und die dazugehörige Hamming-Distanz mit Hd-Dat bezeichnet wird. Der zweite Teil besteht aus n Signaturbits. Dieser wird mit CRC und die dazugehörige Hamming-Distanz mit Hd-CRC bezeichnet. Nach dieser Konvention wird die Hamming-Distanz für die zwei separaten CRC-Tests, Hd-CRC1 und Hd-CRC2 und für den kombinierten CRC-Test als Hd-CRC12 bezeichnet und mittels der Gleichungen (4) bis (6) dargestellt. Es gilt:

$$Hd1 \quad = Hd - Dat + Hd - CRC1 \qquad (4)$$

$$Hd2 \quad = Hd - Dat + Hd - CRC2 \qquad (5)$$

$$Hd12 = Hd - Dat + Hd - CRC1 + Hd - CRC2 =$$
$$= Hd1 + Hd - CRC2 = Hd2 + Hd - CRC1 \qquad (6)$$

Die Hamming-Distanz eines Fehlerfalles für den erweiterten CRC-Test besteht demzufolge aus drei Teilen. Nach der Bestimmung der Fehlergruppen für die zwei konventionellen CRC-Tests CRC1 und CRC2 sind alle drei Teile, die zur Bestimmung der Hamming-Distanz HD12 eines erweiterten CRC-Tests benötigt werden bekannt, sodass die Hamming-Distanz Hd12 eines Fehlerfalles für den erweiterten CRC-Test berechnet werden kann. Das Minimum aus allen Hamming-Distanzen Hd12 für die hierfür möglichen Fehlerfälle ist die Hamming-Distanz HD12. Unter der Annahme, dass HD2 $\geq$ HD1 ist, erfüllt die Hamming-Distanz HD12 eines erweiterten CRC-Test die Gl. (7) stets.

$$HD12 \quad \geq \quad HD2 \quad + \quad d \qquad (7)$$
$$\text{mit } d \quad = \quad 0 \quad \text{für} \quad k > n$$
$$d \quad = \quad 1 \quad \text{für} \quad k \leq n$$

Zur Begründung: Die Hamming-Distanz HD12 des erweiterten CRC-Tests kann nicht kleiner werden als die Hamming-Distanzen HD1, bzw. HD2 der einzelnen CRC-Tests. Somit reduziert sich die Aufgabe auf die Bestimmung des Minimums von HD-CRC1. Für $k \leq n$ besteht eine eindeutige Zuordnung zwischen den Hd-CRC und Hd-Dat in beiden Richtungen, wobei das Datum Null für den Wert von CRC gleich Null zugeordnet wird. Somit nimmt das Minimum von Hd-CRC1 den Wert 1 für $k \leq n$, da der Fehlerfall Null nicht zur Menge der unerkannten Fehlerfälle gehört. Für $k > n$ wird zwangsläufig ein CRC mehrfach zu verschiedenen Daten zugeordnet. Da diese Zuordnung in Schritten von $2^n$ wieder neu bestimmt wird und innerhalb dieser Schritte aber wiederum eindeutig in beiden Richtungen bleibt, wird der Wert von CRC gleich Null zwangsläufig auf Daten $\geq 2^n$ zugeordnet. Somit ist der kleinste Wert von Hd-CRC1 für $k > n$ gleich 0. Die Glg (7) besagt, dass die Hamming-Distanz des erweiterten CRC-Test für $k \leq n$ stets mindestens um einen Punkt größer ist als die maximale Hamming-Distanz der einzelnen CRC-Tests aus denen der Test gebildet wird.

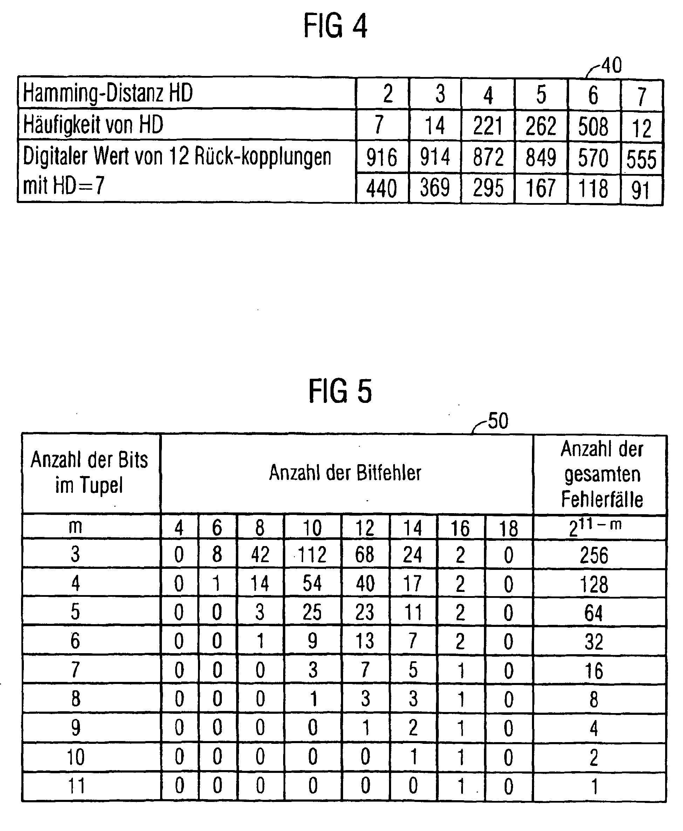

Zunächst wird der Fall $k \leq n$ betrachtet. Bei einem Grossteil der Anwendungen bleibt n in der Regel unter 33, so dass die Anzahl der Nutzbits in diesem Fall maximal 4 Bytes beträgt. Gerade bei fehlersicheren Anwendungen ist es oft der Fall, dass eine geringere Datenmenge mit sehr hoher Sicherheit, d.h. mit möglichst kleinem Restfehlerrisiko übertragen werden muss. Deshalb wird bei der Analyse darauf Wert gelegt, dass für ein spezifisches k abhängig von der Anwendung ein optimales Ergebnis bezüglich der Hamming-Distanz bei dem erweiterten Test gefunden wird. Hierfür wird wiederum das bereits betrachtete Beispiel von N=16 und n=11 herangezogen. Die Rückkopplung besteht hier aus maximal 11 Bits. Es gibt deshalb insgesamt 1024 verschiedene Rückkopplungsmöglichkeiten. Das Ergebnis der systematischen Untersuchung aller Rückkopplungen ist anhand der Tabelle 40 aus der FIG 4 dargestellt. Die häufigste vorkommende Hamming-Distanz beträgt 6 und liegt bei 508 Rückkopplungen vor. Immerhin 12 Rückkopplungen liefern eine Hamming-Distanz von 7.

Aus der Kombination dieser 12 Rückkopplungen mit den restlichen 1023 Rückkopplungen, also aus diesen 12 x 1023 Paare können die Hamming-Distanzen HD12 des erweiterten CRC-Tests nach Gl. (6) ermittelt werden. Einige dieser Paare, insgesamt 6 Paare erhöhen unter Einhaltung der Normempfehlung (eins der verwendeten Polynome ist entweder primitiv oder ein CCIT Polynom) die Hamming-Distanz von 7 auf 12. Dies bedeutet, dass die Restfehlerwahrscheinlichkeit um einen Faktor von fünfzehn Zehnerpotenzen verringert wird, wodurch sich die Restfehlerwahrscheinlichkeit bei diesen Paaren beispielsweise auf eine Größe von ca. $10^{-36}$ reduziert. Darüber hinaus ist die gesamte Verteilung der unerkannten Fehlerfälle nach der Anzahl der Bitfehler ebenfalls bekannt. Somit lässt sich die Restfehlerwahrscheinlichkeit nach Gl. (3) exakt bestimmen.

Für $k > n$ ergeben sich aus der Anwendung des erweiterten CRC-Tests ebenfalls Verbesserungen, allerdings geringfügigerer Art. Für $k \leq n$ jedoch bietet der erweiterte CRC-Test insbesondere für fehlersichere Anwendungen den Vorteil der Kombination der Eigenschaften zweier unabhängiger Rückkopplungen und einer einfachen Handhabung bei der Analyse.

Insbesondere bei der Übertragung von wenigen Bits die mit sehr hoher Sicherheit in einem bereits bestehenden System übertragen werden sollen, werden durch Bildung von m-Bittupeln ebenfalls entscheidende Verbesserungen erzielt. Die Übertragungseinheit eines Systems besteht z.B. aus 7 Bytes Nutzdaten (k=56), die mit einem CCITT Polynom $7^{ten}$ Grades abgesichert werden. Dieser Datenblock hat dann mindestens eine Hamming-Distanz von 4 bis zu einer Blocklänge von 63. Zusätzlich werden alle ungeraden Anzahlen von Bitfehlern erkannt. Soll beispielsweise ein Notaus-Signal mit sehr hoher Sicherheit gesendet werden, lässt sich die Restfehlerwahrscheinlichkeit des Notaus-Signals durch entsprechende Redundanz erhöhen, beispielsweise in dem das Bit mehrfach gesendet wird. Dazu wird ein m-Bittupel mit ungeradem m gebildet. Sind alle m Bits des betreffenden Tupels gleich und hat kein CRC-Fehler stattgefunden, so können im schlimmsten Fall alle m Bits verfälscht sein. Das CCITT Polynom erkennt aber alle ungeraden Anzahlen von Bitfehlern, wodurch mindestens ein (m+1)-Bitfehler vorliegen muss. Die Hamming-Distanz für das m-Bittupel beträgt folglich mindestens m+1. Das Verfahren erlaubt somit für das beispielhaft betrachtete m-Bittupel theoretisch die Erhöhung der Hamming-Distanz auf maximal 56, wenn m=55 beträgt. Je nach Systemanforderung lässt sich folglich mit diesem Verfahren die Restfehlerwahrscheinlichkeit für das betreffende m-Bittupel auf einen gewünschten, niedrigen Wert reduzieren.

Beispielhaft wird im Folgenden mit einem Datenblock von N=18 und n=7, d.h. für 11 Nutzbits, die Restfehlerwahrscheinlichkeit für verschiedene m-Bittupel für m=3 bis m=11 exakt berechnet. Dazu zeigt FIG 5 eine Tabelle 50 zur Verteilung der unerkannten Fehlerfälle für m-Bittupel in Abhängigkeit der Anzahl der Bitfehler für das CCITT Polynom 10. Die Fehlergruppe beinhaltet in diesem Falle insgesamt 2047 Fehlerfälle, die entsprechend dem Datenblock von 16 Bits und 11 Signaturbits abgeleitet werden. Alle Fehlerfälle, bei denen die niederwertigsten m Bits gleich Eins sind, werden aus der Fehlergruppe herausgefiltert. Die Anzahl dieser Fehlerfälle beträgt $2^{11-m}$. Die kleinste Hamming-Distanz Hd dieser Menge ist die Hamming-Distanz für das m-Bittupel. In der Tabelle der FIG 4 ist die Verteilung der Fehlerfälle, bei denen das ganze m-Bittupel fehlerhaft ist, nach Anzahl der gesamten Bitfehlerzahl des Fehlerfalles aufgelistet. Als CCITT Polynom wurde das Polynom 10 mit der Rückkopplung $R_k$=1001010 gewählt. Für n=7 gibt es insgesamt 6 CCITT Polynome mit der Bezeichnung 10, 17, 20, 27, 34 und 54. Wie man aus der Tabelle der FIG 4 entnehmen kann, ist die tatsächliche Hamming-Distanz für ein m-Bittupel in der Regel für alle ungeraden Werte von m mindestens 2 Punkte höher als m+1. Da nun die gesamte Fehlerverteilung nach Anzahl der Bitfehler bekannt ist, lässt sich die Restfehlerwahrscheinlichkeit für sämtliche m-Bittupel mit den verschiedenen Werten für m exakt bestimmen. Dabei lässt sich für große k (k>30) wegen des hohen Datenaufkommens zumindest die untere Grenze der Hamming-Distanz, wie das obige Beispiel zeigt, für das m-Bittupel auf m+1 abschätzen. Eine exakte Bestimmung der Restfehlerwahrscheinlichkeit ist für diese Fälle nicht nötig. Die Restfehlerwahrscheinlichkeit wird dann für ein entsprechendes m-Bittupel durch die G1. (8) dargestellt.

$$R(p)_{m\text{-Bittupel}} \leq p^{m+1} \times q^{18-m-1} \qquad (8)$$

Grundsätzlich können mehrere Bits fehlersicher übertragen werden. Beim vorliegenden Beispiel kann z.B. ein ganzes Byte fehlersicher übertragen werden. In diesem Fall werden dann 8 7-Bittupel gebildet, die mit einer Hamming-Distanz von mindestens 8 abgesichert werden können. Die Restfehlerwahrscheinlichkeit wird dann ebenfalls gemäß Gl. (8) bestimmt.

Zusammenfassend ermöglicht die Erfindung eine schnelle und präzise Gewinnung der Fehlerfälle, die bei der Datenübertragung nicht erkannt werden können. Die genaue Kenntnis der Fehlerverteilung und deren Häufigkeit nach Bitfehlerzahl ermöglicht die exakte Bestimmung der Restfehlerwahrscheinlichkeit gemäß G1. (3). Auch bei großen Datenblöcken lässt sich die Erfindung vorteilhaft anwenden. Für einen großen Datenblock mit N=1024 und n=24 ergeben sich insgesamt $2^{1000}$ fehlerhafte Kombinationen, die bei einem CRC-Test unerkannt bleiben. Zur Darstellung jedes beliebigen Fehlerfalls sind dann 1000 linear unabhängige Grundelemente nötig, sodass relativ schnell nachgewiesen werden kann, ob eine spezifische Fehlerkombination grundsätzlich erkennbar ist. Darüber hinaus erlaubt die Betrachtungsweise wertvolle Rückschlüsse auf die Menge der Fehlerfälle. So beträgt beispielsweise für k ≥ n die Summe aller Hamming-Distanzen sämtlicher Elemente einer Fehlergruppe (Summenbildung von Eins über sämtliche Fehlerfälle) unabhängig von der gewählten Rückkopplung $R_k$ stets $N2^{(k-1)}$. Dies wird auch als Hamming-Gewicht der Gruppe bezeichnet und durch die G1. (9) wiedergegeben. Dabei ist H(m) die Häufigkeit des Fehlerfalles mit einem m-Bitfehler.

$$\sum_{m=2}^{m=N} H(m) * m = N2^{k-1} \qquad (9)$$

Für große Datenmengen ist die Bestimmung der Gesamtheit aller möglichen Fehlerfälle nicht notwendig. Es genügt, wenn die Hamming-Distanz d für die betrachtete Anwendung bekannt ist. Dann lässt sich die obere Grenze der Restfehlerwahrscheinlichkeit R(p) nach der Gl. (10) abschätzen.

$$R(p) = \sum_{m=d}^{m=N} H(m) \times p^m \times q^{N-m} < 1 - \sum_{m=0}^{m=d-1} \binom{N}{m} \times p^m \times q^{N-m} \qquad (10)$$

Durch Einsetzen der Binomialkoeffizienten anstelle der Häufigkeit H(m) in die Gl. (3) wird die so berechnete Restfehlerwahrscheinlichkeit vergrößert. Die Summe der Terme m=d bis m=N lassen sich, wie in der G1. (10) dargestellt, aus der G1. (2) ableiten. Ist zusätzlich zur Hamming-Distanz d auch die Häufigkeit der Fehlerfälle für d-Bitfehler bekannt, so lässt sich die obere Grenze mittels der Gl. (11) noch genauer abschätzen.

$$R(p) = \sum_{m=d}^{m=N} H(m)\,xp^m xq^{N-m} \; < \; H(d)\,x\,p^d\,x\,q^{N-d} + 1 - \sum_{m=0}^{m=d} \binom{N}{m} xp^m xq^{N-m} \quad (11)$$

Mittels der G1. (10) und (11) kann die Restfehlerwahrscheinlichkeit gut und effektiv abgeschätzt werden. Die primitiven sowie die CCITT-Polynome haben mindestens eine Hamming-Distanz von 3 bzw. 4 bis zu einer Blocklänge von $2^n-1$ bzw. von $2^{n-1}-1$. Bei der Anwendung dieser Polynome kann die Restfehlerwahrscheinlichkeit auch für große Datenblöcke schnell abgeschätzt werden. Die Erfindung ist dabei insbesondere für sicherheitsrelevante Systeme, aber auch für die konventionelle Datenübertragungstechnik anwendbar und von erheblicher Bedeutung.

**Patentansprüche**

1.  Verfahren zur definierten Reduzierung der Restfehlerwahrscheinlichkeit bei der Übertragung von Daten zwischen wenigstens einem Sender (1) und wenigstens einem Empfänger (2), die mittels einer Übertragungsstrecke (3) miteinander verbunden sind, wobei für die Restfehlerwahrscheinlichkeit R(p) gilt:

$$R(p) = \sum_{m=d}^{N} H(m) \times p^m \times q^{N-m},$$

    mit

        m - Zahl der verfälscht empfangenen Bits,
        d - Hamming-Distanz eines angewendeten Codes,
        N - Bitlänge des übertragenen Datenblocks,
        H(m) - Häufigkeit der m-Bitfehler, die der Code nicht erkennen kann,
        p - Bitfehlerrate bei einer Datenübertragung und
        q - Wahrscheinlichkeit, dass ein Bit unverfälscht empfangen wird,

    wobei der Sender (1) Mittel zum Codieren und Senden von Daten und der Empfänger (2) Mittel zum Empfangen, Codieren und Vergleichen von Daten aufweist, mit folgenden Schritten:

        - Generieren eines ersten Codes, welcher eine erste Hamming Distanz aufweist, mittels einer ersten Codiervorschrift aus den zu sendenden Daten durch den Sender (1),
        - Generieren eines zweiten Codes, welcher eine zweite Hamming-Distanz aufweist, mittels einer zweiten Codiervorschrift aus den zu sendenden Daten durch den Sender (1),
        - Senden der Daten an den Empfänger (2),
        - Generieren eines dritten Codes, welcher die erste Hamming-Distanz aufweist, mittels der ersten Codiervorschrift aus den empfangenen Daten durch den Empfänger (2),
        - Generieren eines vierten Codes, welcher die zweite Hamming-Distanz aufweist, mittels der zweiten Codiervorschrift aus den empfangenen Daten durch den Empfänger (2),
        - Senden des ersten und des zweiten Codes an den Empfänger (2),
        - Vergleichen des ersten mit dem dritten Code und des zweiten mit dem vierten Code durch den Empfänger (2),

    Auswerten des Ergebnisses des Vergleichs des ersten mit dem dritten Code und des zweiten mit dem vierten Code durch den Empfänger (2),
    wobei der Sender (1) als Mittel zum Codieren der Daten wenigstens ein erstes (8) und ein zweites linear rückgekoppeltes Schieberegister (9) aufweist und der Empfänger (2) als Mittel zum Codieren der Daten wenigstens ein drittes (10) und ein viertes linear rückgekoppeltes Schieberegister (11) aufweist, wobei das erste (8) und das dritte linear rückgekoppelte Schieberegister (9) jeweils die gleiche Codiervorschrift verwenden und das zweite (10) und das vierte linear rückgekoppelte Schieberegister (11) jeweils die gleiche Codiervorschrift verwenden, wobei die jeweilige Codiervorschrift durch eine entsprechende lineare Rückkopplung der jeweiligen Schieberegister (8,9,10,11) realisiert ist und wobei zur Bestimmung der Hamming-Distanz der Codiervorschriften und/oder der generierten Codes die Gesamtheit aller bei der jeweiligen Datenübertragung möglichen unerkannten Fehler aus einer Anzahl linear unabhängiger Datenblöcke gebildet wird, wobei die Anzahl der linear unabhängigen Datenblöcke jeweils der Anzahl der Nutzdatenbits entspricht.

2. Verfahren nach Anspruch 1,
   **dadurch gekennzeichnet,**
   **dass** ein Code aus Signaturbits besteht.

3. Verfahren nach einem der Ansprüche 1 oder 2,
   **dadurch gekennzeichnet,**
   **dass** die zu übertragenden Daten aus Nutzdatenbits und/oder Signaturbits bestehen.

4. Verfahren nach einem der vorhergehenden Ansprüche,
   **dadurch gekennzeichnet,**
   **dass** das Verfahren zur definierten Reduzierung der Restfehlerwahrscheinlichkeit von unerkannten Fehlern vorgesehen ist.

5. Verfahren nach einem der vorhergehenden Ansprüche,
   **dadurch gekennzeichnet,**
   **dass** das erste linear rückgekoppelte Schieberegister (8) und das zweite linear rückgekoppelte Schieberegister (9) unterschiedliche Codiervorschriften verwenden.

6. Verfahren nach einem der vorhergehenden Ansprüche,
   **dadurch gekennzeichnet,**
   **dass** der Code, der durch die zweite Codiervorschrift generiert wird, eine größere oder kleinere Hamming-Distanz aufweist als der Code, der durch die erste Codiervorschrift generiert wird.

7. Verfahren nach einem der vorhergehenden Ansprüche,
   **dadurch gekennzeichnet,**
   **dass** der Code, der durch die zweite Codiervorschrift generiert wird, eine größere oder kleinere Anzahl an Signaturbits aufweist als der Code, der durch die erste Codiervorschrift generiert wird.

8. Verfahren nach einem der vorhergehenden Ansprüche,
   **dadurch gekennzeichnet,**
   **dass** die Hamming-Distanz des erzeugten Codes, der in Kombination verwendeten ersten und zweiten Codiervorschrift größer als die größere der beiden Hamming-Distanzen, der durch die erste oder zweite Codiervorschrift erzeugten Codes ist, wenn die Anzahl der zu übertragenden Nutzdatenbits kleiner oder gleich der geringsten Anzahl der jeweils zugehörigen Signaturbits ist.

9. Sender (1) für ein System (15) zur definierten Reduzierung der Restfehlerwahrscheinlichkeit bei der Übertragung von Daten, wobei der Sender (1) Mittel zum Codieren und Senden von Daten aufweist, wobei für die Restfehlerwahrscheinlichkeit R(p) gilt:

$$R(p) = \sum_{m=d}^{N} H(m) \times p^{m} \times q^{N-m},$$

mit

m - Zahl der verfälscht empfangenen Bits,
d - Hamming-Distanz eines angewendeten Codes,
N - Bitlänge des übertragenen Datenblocks,
H(m) - Häufigkeit der m-Bitfehler, die der Code nicht erkennen kann,
p - Bitfehlerrate bei einer Datenübertragung und

q - Wahrscheinlichkeit, dass ein Bit unverfälscht empfangen wird,

wobei der Sender (1) einen ersten Code, welcher eine erste Hamming-Distanz aufweist, mittels einer ersten Codiervorschrift und einen zweiten Code, welcher eine zweite Hamming-Distanz aufweist, mittels einer zweiten Codiervorschrift aus den zu sendenden Daten generiert und die Daten und den ersten und den zweiten Code an den Empfänger (2) sendet, wobei der Sender (1) als Mittel zum Codieren der Daten wenigstens ein erstes (8) und ein zweites linear rückgekoppeltes Schieberegister (9) aufweist, wobei das erste linear rückgekoppelte Schieberegister (8) und das zweite linear rückgekoppelte Schieberegister (9) unterschiedliche Codiervorschriften verwenden, wobei die jeweilige Codiervorschrift durch eine entsprechende lineare Rückkopplung der jeweiligen Schieberegister (8,9) realisiert ist und wobei zur Bestimmung der Hamming-Distanz der Codiervorschriften und/oder der generierten Codes die Gesamtheit aller bei der jeweiligen Datenübertragung möglichen unerkannten Fehler aus einer Anzahl linear unabhängiger Datenblöcke gebildet wird, wobei die Anzahl der linear unabhängigen Datenblöcke jeweils der Anzahl der Nutzdatenbits entspricht.

10. Sender nach Anspruch 9,
**dadurch gekennzeichnet,**
**dass** ein generierter Code aus Signaturbits besteht.

11. Sender nach einem der Ansprüche 9 oder 10,
**dadurch gekennzeichnet,**
**dass** die zu sendenden Daten aus Nutzdatenbits und/oder Signaturbits bestehen.

12. Sender nach einem der Ansprüche 9 bis 11,
**dadurch gekennzeichnet,**
**dass** das Verfahren zur definierten Reduzierung der Restfehlerwahrscheinlichkeit von unerkannten Fehlern vorgesehen ist.

13. Sender nach einem der Ansprüche 9 bis 12,
**dadurch gekennzeichnet,**
**dass** der Code, der durch die zweite Codiervorschrift generiert wird, eine größere oder kleinere Hamming-Distanz aufweist als der Code, der durch die erste Codiervorschrift generiert wird.

14. Sender nach einem der Ansprüche 9 bis 13,
**dadurch gekennzeichnet,**
**dass** der Code, der durch die zweite Codiervorschrift generiert wird, eine größere oder kleinere Anzahl an Signaturbits aufweist als der Code, der durch die erste Codiervorschrift generiert wird.

15. Sender nach einem der Ansprüche 9 bis 14,
**dadurch gekennzeichnet,**
**dass** die Hamming-Distanz des erzeugten Codes, der in Kombination verwendeten ersten und zweiten Codiervorschrift größer als die größere der beiden Hamming-Distanzen, der durch die erste oder zweite Codiervorschrift erzeugten Codes ist, wenn die Anzahl der zu übertragenden Nutzdatenbits kleiner oder gleich der geringsten Anzahl der jeweils zugehörigen Signaturbits ist.

16. Empfänger (2) für ein System (15) zur definierten Reduzierung der Restfehlerwahrscheinlichkeit bei der Übertragung von Daten, wobei der Empfänger (2) Mittel zum Empfangen, Codieren und Vergleichen von Daten aufweist, wobei für die Restfehlerwahrscheinlichkeit R(p) gilt:

$$R(p) = \sum_{m=d}^{N} H(m) \times p^{m} \times q^{N-m},$$

mit

m - Zahl der verfälscht empfangenen Bits,
d - Hamming-Distanz eines angewendeten Codes,
N - Bitlänge des übertragenen Datenblocks,

H(m) - Häufigkeit der m-Bitfehler, die der Code nicht erkennen kann,

p - Bitfehlerrate bei einer Datenübertragung und

q - Wahrscheinlichkeit, dass ein Bit unverfälscht empfangen wird,

wobei der Empfänger (2) gesendeten Daten, einen ersten gesendeten Code, welcher eine erste Hamming-Distanz aufweist, und einen zweiten gesendeten Code, welcher eine zweite Hamming-Distanz aufweist, empfängt, einen dritten Code, welcher die erste Hamming-Distanz aufweist, mittels einer ersten Codiervorschrift und einen vierten Code, welcher die zweite Hamming-Distanz aufweist, mittels einer zweiten Codiervorschrift aus den empfangenen Daten generiert, den ersten mit dem dritten Code und den zweiten mit dem vierten Code vergleicht und das Ergebnis des Vergleichs des ersten mit dem dritten Code und des zweiten mit dem vierten Code auswertet, wobei der Empfänger (2) als Mittel zum Codieren der Daten wenigstens ein drittes (10) und ein viertes linear rückgekoppeltes Schieberegister (11) aufweist, wobei das dritte linear rückgekoppelte Schieberegister (10) und das vierte linear rückgekoppelte Schieberegister (11) unterschiedliche Codiervorschriften verwenden, wobei die jeweilige Codiervorschrift durch eine entsprechende lineare Rückkopplung der jeweiligen Schieberegister (10,11) realisiert ist und wobei das dritte linear rückgekoppelte Schieberegister (10) eine erste Codiervorschrift und das vierte linear rückgekoppelte Schieberegister (11) eine zweite Codiervorschrift verwendet und wobei zur Bestimmung der Hamming-Distanz der Codiervorschriften und/oder der generierten Codes die Gesamtheit aller bei der jeweiligen Datenübertragung möglichen unerkannten Fehler aus einer Anzahl linear unabhängiger Datenblöcke gebildet wird, wobei die Anzahl der linear unabhängigen Datenblöcke jeweils der Anzahl der Nutzdatenbits entspricht.

17. Empfänger nach Anspruch 16,
**dadurch gekennzeichnet,**
**dass** ein generierter Code aus Signaturbits besteht.

18. Empfänger nach einem der Ansprüche 16 oder 17,
**dadurch gekennzeichnet,**
**dass** die empfangenen Daten aus Nutzdatenbits und/oder Signaturbits bestehen.

19. Empfänger nach einem der Ansprüche 16 bis 18,
**dadurch gekennzeichnet,**
**dass** das System zur definierten Reduzierung der Restfehlerwahrscheinlichkeit vorgesehen ist.

20. Empfänger nach einem der Ansprüche 16 bis 19,
**dadurch gekennzeichnet,**
**dass** der Code, der durch die zweite Codiervorschrift generiert wird, eine größere oder kleinere Hamming-Distanz aufweist als der Code, der durch die erste Codiervorschrift generiert wird.

21. Empfänger nach einem der Ansprüche 16 bis 20,
**dadurch gekennzeichnet,**
**dass** der Code, der durch die zweite Codiervorschrift generiert wird, eine größere oder kleinere Anzahl an Signaturbits aufweist als der Code, der durch die erste Codiervorschrift generiert wird.

22. Empfänger nach einem der Ansprüche 16 bis 21,
**dadurch gekennzeichnet,**
**dass** die Hamming-Distanz des erzeugten Codes, der in Kombination verwendeten ersten und zweiten Codiervorschrift größer als die größere der beiden Hamming-Distanzen, der durch die erste oder zweite Codiervorschrift erzeugten Codes ist, wenn die Anzahl der empfangenen Nutzdatenbits kleiner oder gleich der geringsten Anzahl der jeweils zugehörigen Signaturbits ist.

23. System (15), insbesondere Automatisierungssystem, zur definierten Reduzierung der Restfehlerwahrscheinlichkeit bei der Übertragung von Daten, wobei für die Restfehlerwahrscheinlichkeit R(p) gilt:

$$R(p) = \sum_{m=d}^{N} H(m) \times p^m \times q^{N-m},$$

mit

m - Zahl der verfälscht empfangenen Bits,
d - Hamming-Distanz eines angewendeten Codes,
N - Bitlänge des übertragenen Datenblocks,
H(m) - Häufigkeit der m-Bitfehler, die der Code nicht erkennen kann,
p - Bitfehlerrate bei einer Datenübertragung und
q - Wahrscheinlichkeit, dass ein Bit unverfälscht empfangen wird,

wobei das System (15) wenigstens einen Sender (1) mit den Merkmalen nach einem der Ansprüche 9 bis 15 und wenigstens einen Empfänger (2) mit den Merkmalen nach einem der Ansprüche 16 bis 22 aufweist, wobei der Sender (1) und der Empfänger (2) mittels einer Übertragungsstrecke (3) miteinander verbunden sind und wobei die Daten zwischen dem Sender (1) und dem Empfänger (2) oder umgekehrt über die Übertragungsstrecke (3) übertragen werden, wobei das Generieren der Codes mittels Codiervorschriften erfolgt und wobei zur Bestimmung der Hamming-Distanz der Codiervorschriften und/oder der generierten Codes die Gesamtheit aller bei der jeweiligen Datenübertragung unerkannten Fehler aus einer Anzahl linear unabhängiger Datenblöcke gebildet wird, wobei die Anzahl der linear unabhängigen Datenblöcke jeweils der Anzahl der Nutzdatenbits entspricht.

**Claims**

1. Method for defined reduction of the residual error probability in the transmission of data between at least one transmitter (1) and at least one receiver (2), which are connected to one another by means of a transmission path (3), with the residual error probability R(p) being:

$$R(p) = \sum_{m=d}^{N} H(m) \times p^{m} \times q^{N-m},$$

where

m - number of incorrectly received bits,
d - Hamming distance of a code that is being used,
N - bit length of the transmitted data block,
H(m) - frequency of the m-bit error which the code cannot identify,
p - bit error rate during a data transmission, and
q - probability that a bit is received without being corrupted,

with the transmitter (1) having means for coding and transmission of data, and the receiver (2) having means for reception, coding and comparison of data, having the following steps:

- generation of a first code, which has a first Hamming distance, by means of a first coding rule from the data to be transmitted by the transmitter (1)
- generation of a second code, which has a second Hamming distance, by means of a second coding rule from the data to be transmitted by the transmitter (1),
- transmission of the data to the receiver (2),
- generation of a third code, which has the first Hamming distance, by means of the first coding rule from the data received by the receiver (2),
- generation of a fourth code, which has the second Hamming distance, by means of the second coding rule from the data received by the receiver (2),
- transmission of the first and of the second code to the receiver (2),
- comparison of the first code with the third code and of the second code with the fourth code by the receiver (2),

evaluation of the result of the comparison of the first code with the third code and of the second code with the fourth code by the receiver (2),
with the transmitter (1) having at least one first shift register (8) and one second linear feedback shift register (9), as the means for coding of the data, and the receiver (2) having at least one third shift register (10) and one fourth linear feedback shift register (11), as the means for coding the data, with the first shift register (8) and the third linear feedback shift register (9), each using the same coding rule, and with the second shift register (10) and the fourth linear feedback shift register (11), each using the same coding rule, with the respective coding rule being provided by corresponding linear feedback of the respective shift registers (8, 9, 10, 11), and
with the totality of all of the unidentified errors that are possible in the respective data transmission being formed from a number of linearly independent data blocks in order to determine the Hamming distance of the coding rules and/or of the generated codes, and with the number of linearly independent data blocks in each case corresponding to the number of payload data bits.

2. Method according to Claim 1,
**characterized**
**in that** a code comprises signature bits.

3. Method according to one of Claims 1 or 2,
**characterized**
**in that** the data to be transmitted comprises payload data bits and/or signature bits.

4. Method according to one of the preceding claims,
**characterized**
**in that** the method is intended for defined reduction in the residual error probability of unidentified errors.

5. Method according to one of the preceding claims,
**characterized**
**in that** the first linear feedback shift register (8) and the second linear feedback shift register (9) use different coding rules.

6. Method according to one of the preceding claims,
**characterized**
**in that that** code which is generated by the second coding rule has a greater or lesser Hamming distance than that code which is generated by the first coding rule.

7. Method according to one of the preceding claims,
**characterized**
**in that that** code which is generated by the second coding rule has a greater or lesser number of signature bits than that code which is generated by the first coding rule.

8. Method according to one of the preceding claims,
**characterized**
**in that** the Hamming distance of the code which is produced and in combination with the first and the second coding rule that are used is greater than the greater of the two Hamming distances of the codes which are produced by the first or the second coding rule when the number of payload bits to be transmitted is less than or equal to the smallest number of the respectively associated signature bits.

9. Transmitter (1) for a system (15) for defined reduction of the residual error probability in the transmission of data, with the transmitter (1) having means for coding and transmitting data, and with the residual error probability R(p) being:

$$R(p) = \sum_{m=d}^{N} H(m) \times p^{m} \times q^{N-m},$$

where

m - number of incorrectly received bits,
d - Hamming distance of a code that is being used,
N - bit length of the transmitted data block,
H(m) - frequency of the m-bit error which the code cannot identify,

p - bit error rate during a data transmission, and

q - probability that a bit is received without being corrupted,

with the transmitter (1) generating a first code, which has a first Hamming distance, by means of a first coding rule and generating a second code, which has a second Hamming distance, by means of a second coding rule from the data to be transmitted, and transmitting the data and the first and the second code to the receiver (2), with the transmitter (1) as the means for coding the data having at least one first shift register (8) and one second linear feedback shift register (9), with the first linear feedback shift register (8) and the second linear feedback shift register (9) using different coding rules, with the respective coding rule being provided by corresponding linear feedback of the respective shift registers (8, 9), and with the totality of all unidentified errors which are possible in the respective data transmission being formed from a number of linearly independent data blocks in order to determine the Hamming distance of the coding rules and/or of the generated codes, and with the number of linearly independent data blocks in each case corresponding to the number of payload data bits.

10. Transmitter according to Claim 9,
**characterized**
**in that** a generated code comprises signature bits.

11. Transmitter according to one of Claims 9 or 10,
**characterized**
**in that** the data to be transmitted comprises payload data bits and/or signature bits.

12. Transmitter according to one of Claims 9 to 11,
**characterized**
**in that** the method is intended for defined reduction in the residual error probability of unidentified errors.

13. Transmitter according to one of Claims 9 to 12,
**characterized**
**in that that** code which is generated by the second coding rule has a greater or lesser Hamming distance than that code which is generated by the first coding rule.

14. Transmitter according to one of Claims 9 to 13,
**characterized**
**in that that** code which is generated by the second coding rule has a greater or lesser number of signature bits than that code which is generated by the first coding rule.

15. Transmitter according to one of Claims 9 to 14,
**characterized**
**in that** the Hamming distance of the code which is produced and in combination with the first and the second coding rule that are used is greater than the greater of the two Hamming distances of the codes which are produced by the first or the second coding rule when the number of payload bits to be transmitted is less than or equal to the smallest number of the respectively associated signature bits.

16. Receiver (2) for a system (15) for defined reduction of the residual error probability in the transmission of data, with the receiver (2) having means for reception, coding and comparison of data, and with the residual error probability R(p) being:

$$R(p) \ = \ \sum_{m=d}^{N} H(m) \ \times \ p^m \ \times \ q^{N-m},$$

where

m - number of incorrectly received bits,

d - Hamming distance of a code that is being used,

N - bit length of the transmitted data block,

H(m) - frequency of the m-bit error which the code cannot identify,
p - bit error rate during a data transmission, and
q - probability that a bit is received without being corrupted,

with the receiver (2) receiving transmitted data, a first transmitted code which has a first Hamming distance, and a second transmitted code which has a second Hamming distance, generating a third code which has the first Hamming distance by means of a first coding rule and generating a fourth code which has the second Hamming distance by means of a second coding rule from the received data, comparing the first code with the third code and the second code with the fourth code, and evaluating the result of the comparison of the first code with the third code and of the second code with the fourth code, with the receiver (2) having at least one third (10) and one fourth linear feedback shift register (11) as the means for coding the data, with the third linear feedback shift register (10) and the fourth linear feedback shift register (11) using different coding rules, with the respective coding rule being provided by corresponding linear feedback of the respective shift registers (10, 11), and with the third linear feedback shift register (10) using a first coding rule and the fourth linear feedback shift register (11) using a second coding rule, and with the totality of all the unidentified errors which are possible in the respective data transmission being formed from a number of linearly independent data blocks in order to determine the Hamming distance of the coding rules and/or of the generated codes, and with the number of linearly independent data blocks in each case corresponding to the number of payload data bits.

17. Receiver according to Claim 16,
 **characterized**
 **in that** a generated code comprises signature bits.

18. Receiver according to one of Claims 16 or 17,
 **characterized**
 **in that** the received data comprises payload data bits and/or signature bits.

19. Receiver according to one of Claims 16 to 18,
 **characterized**
 **in that** the system is intended for defined reduction of the residual error probability.

20. Receiver according to one of Claims 6 to 19,
 **characterized**
 **in that that** code which is generated by the second coding rule has a greater or lesser Hamming distance than that code which is generated by the first coding rule.

21. Receiver according to one of Claims 16 to 20,
 **characterized**
 **in that that** code which is generated by the second coding rule has a greater or lesser number of signature bits than that code which is generated by the first coding rule.

22. Receiver according to one of Claims 16 to 21,
 **characterized**
 **in that** the Hamming distance of the code which is produced in combination with the first and the second coding rule that are used is greater than the greater of the two Hamming distances of the codes which are produced by the first or the second coding rule when the number of received payload data bits is less than or equal to the smallest number of the respectively associated signature bits.

23. System (15), in particular an automation system, for defined reduction in the residual error probability in the transmission of data, with the residual error probability R(p) being:

$$R(p) \;=\; \sum_{m=d}^{N} H(m) \,\times\, p^{m} \,\times\, q^{N-m},$$

where

m - number of incorrectly received bits,
d - Hamming distance of a code that is being used,
N - bit length of the transmitted data block,
H(m) - frequency of the m-bit error which the code cannot identify,
p - bit error rate during a data transmission, and
q - probability that a bit is received without being corrupted,

with the system (15) having at least one transmitter (1) with the features according to one of Claims 9 to 15 and at least one receiver (2) with the features according to one of Claims 16 to 22, with the transmitter (1) and the receiver (2) being connected to one another by means of a transmission path (3), and with the data being transmitted between the transmitter (1) and the receiver (2), or vice versa, via the transmission path (3), with the codes being generated by means of coding rules and with the totality of all errors which are unidentified in the respective data transmission being formed from a number of linearly independent data blocks in order to determine the Hamming distance of the coding rules and/or of the generated codes, and with the number of linearly independent data blocks in each case corresponding to the number of payload data bits.

**Revendications**

1. Procédé permettant de réduire d'une façon définie la probabilité d'erreurs résiduelles lors de la transmission de données entre au moins un émetteur (1) et au moins un récepteur (2) qui sont reliés entre eux par une liaison de transmission (3), la probabilité d'erreurs résiduelles R(p) étant définie par :

$$R(p) = \sum_{m=d}^{N} H(m) \times p^m \times q^{N-m}$$

où
m est le nombre de bits erronés reçus,
d est la distance de Hamming d'un code utilisé,
N est la longueur binaire du bloc de données transmis,
H(m) est la fréquence des erreurs de m bits, que le code ne peut pas reconnaître,
p est le taux d'erreur de bit pour une transmission de données et
q est la probabilité de réception d'un bit non erroné,
l'émetteur (1) comportant des moyens de codage et d'émission de données et le récepteur (2) comportant des moyens de réception, de codage et de comparaison de données, ledit procédé comportant les étapes suivantes consistant à :

- générer un premier code, ayant une première distance de Hamming, au moyen d'une première règle de codage à partir des données à envoyer dans l'émetteur (1),
- générer un deuxième code, ayant une deuxième distance de Hamming, au moyen d'une deuxième règle de codage à partir des données à envoyer par l'émetteur (1),
- envoyer les données au récepteur (2),
- générer un troisième code, ayant la première distance de Hamming, au moyen de la première règle de codage à partir des données reçues dans le récepteur (2),
- générer un quatrième code, ayant une deuxième distancede Hamming, au moyen de la deuxième règle de codage à partir des données reçues dans le récepteur (2),
- envoyer le premier code et le deuxième code au récepteur (2),
- comparer le premier code au troisième code et le deuxième code au quatrième code dans le récepteur (2),
- exploiter le résultat de la comparaison entre le premier code et le troisième code et entre le deuxième code et le quatrième code dans le récepteur (2),

l'émetteur (1) comportant comme moyen de codage des données au moins un premier registre à décalage à boucle fermée linéaire (8) et un deuxième registre à décalage à boucle fermée linéaire linéaire (9), et le récepteur (2) comportant comme moyen de codage des données au moins un troisième registre à décalage à boucle fermée linéaire (10) et un quatrième registre à décalage à boucle fermée linéaire (11), le premier registre à décalage à boucle fermée linéaire (8) et le troisième registre à décalage à boucle fermée linéaire(9) utilisant chacun la même règle de codage et le deuxième registre à décalage à boucle fermée linéaire (10) et le quatrième registre à décalage à boucle fermée linéaire (11) utilisant chacun la même règle de codage, la règle de codage respective étant réalisée par une rétroaction linéaire correspondante du registre à décalage respectif (8, 9, 10, 11) et, pour déterminer la distance de Hamming des règles de codage et/ou des codes générés, la totalité de toutes les erreurs possibles non reconnues lors de la transmission de données respective étant formée à partir d'un nombre de blocs de données linéairement indépendants, le nombre des blocs de données linéairement indépendants correspondant respectivement au nombre des bits de données utiles.

**2.** Procédé selon la revendication 1, **caractérisé en ce qu'**un code est constitué de bits de signature.

**3.** Procédé selon l'une des revendications 1 ou 2, **caractérisé en ce que** les données à transmettre sont constituées de bits de données utiles et/ou de bits de signature.

**4.** Procédé selon l'une des revendications précédentes, **caractérisé en ce que** le procédé est destiné à réduire d'une façon définie la probabilité d'erreurs inconnues résiduelles.

**5.** Procédé selon l'une des revendications précédentes, **caractérisé en ce que** le premier registre à décalage à boucle fermée linéaire (8) et le deuxième registre à décalage à boucle fermée linéaire (9) utilisent des règles de codage différentes.

**6.** Procédé selon l'une des revendications précédentes, **caractérisé en ce que** le code généré par la deuxième règle de codage a une distance de Hamming qui est supérieure ou inférieure à celle du code généré par la première règle de codage.

**7.** Procédé selon l'une des revendications précédentes, **caractérisé en ce que** le code généré par la deuxième règle de codage a un nombre de bits de signature qui est supérieur ou inférieur à celui du code généré par la première règle de codage.

**8.** Procédé selon l'une des revendications précédentes, **caractérisé en ce que** la distance de Hamming du code généré des première et deuxième règles de codage utilisées en combinaison est supérieure à la plus grande des deux distances de Hamming du code généré par la première ou deuxième règle de codage lorsque le nombre des bits de données utiles à transmettre est inférieur ou égal au plus petit nombre des bits de signature associés.

**9.** Emetteur (1) destiné à un système (15) de réduction de façon définie de la probabilité d'erreurs résiduelles lors de la transmission de données, l'émetteur (1) comportant des moyens de codage et d'émission de données, la probabilité d'erreurs résiduelles R(p) étant définie par :

$$R(p) = \sum_{m=d}^{N} H(m) \times p^{m} \times q^{N-m}$$

où
m est le nombre de bits erronés reçus,
d est la distance de Hamming d'un code utilisé,
N est la longueur binaire du bloc de données transmis,
H(m) est la fréquence des erreurs de m bits d'erreur, que le code ne peut pas reconnaître,
p est le taux d'erreur de bit pour une transmission de données et
q est la probabilité de réception d'un bit non erroné,
l'émetteur (1) générant un premier code, ayant une première distance de Hamming, au moyen d'une première règle de codage et un deuxième code, ayant une deuxième distance de Hamming, au moyen d'une deuxième règle de codage à partir des données à émettre et envoyant les données et les premier et deuxième codes au récepteur (2), l'émetteur (1) comportant comme moyen de codage des données au moins un premier registre à décalage à boucle fermée linéaire (8) et un deuxième registre à décalage à boucle fermée linéaire (9), le premier registre à décalage à boucle fermée linéaire (8) et le deuxième registre à décalage à boucle fermée linéaire (9) utilisant des règles de codage différentes, la règle de codage respective étant réalisée par une rétroaction linéaire correspondante des registres à décalage respectif (8, 9) et, pour déterminer la distance de Hamming des règles de codage et/ou des codes générés, la totalité de toutes les erreurs possibles non reconnues lors de la transmission de données respective étant formée à partir d'un nombre de blocs de données linéairement indépendants, le nombre des blocs de données linéairement indépendants correspondant respectivement au nombre des bits de données utiles.

10. Émetteur selon la revendication 9, **caractérisé en ce qu'**un code généré est constitué de bits de signature.

11. Émetteur selon l'une des revendications 9 ou 10, **caractérisé en ce que** les données à envoyer sont constituées de bits de données utiles et/ou de bits de signature.

12. Émetteur selon l'une des revendications 9 à 11, **caractérisé en ce que** le procédé est destiné à réduire de façon définie la probabilité d'erreurs résiduelles inconnues.

13. Emetteur selon l'une des revendications 9 à 12, **caractérisé en ce que** le code généré par la deuxième règle de codage a une distance de Hamming qui est supérieure ou inférieure à celle du code généré par la première règle de codage.

14. Emetteur selon l'une des revendications 9 à 13, **caractérisé en ce que** le code généré par la deuxième règle de codage a un nombre de bits de signature qui est supérieur ou inférieur à celui du code généré par la première règle de codage.

15. Emetteur selon l'une des revendications 9 à 14, **caractérisé en ce que** la distance de Hamming du code généré des première et deuxième règles de codage utilisées en combinaison est supérieure à la plus grande des deux distances de Hamming du code généré par la première ou deuxième règle de codage lorsque le nombre des bits de données utiles à transmettre est inférieur ou égal au plus petit nombre des bits de signature associés.

16. Récepteur (2) destiné à un système (15) destiné à réduire de façon définie la probabilité d'erreurs résiduelles lors de la transmission de données, le récepteur (2) comportant des moyens de réception, de codage et de compraison de données, la probabilité d'erreurs résiduelles R(p) étant définie par :

$$R(p) = \sum_{m=d}^{N} H(m) \times p^{m} \times q^{N-m}$$

où
m est le nombre de bits erronés reçus,
d est la distance de Hamming d'un code utilisé,
N est la longueur binaire du bloc de données transmis,
H(m) est la fréquence des erreurs de m bits, que le code ne peut pas reconnaître,
p est le taux d'erreur de bit pour une transmission de données et
q est la probabilité de réception d'un bit non erroné,
le récepteur (1) recevant des données émises, un premier code émis, ayant une première distance de Hamming, et un deuxième code émis, ayant une deuxième distance de Hamming, générant un troisième code, ayant une première distance de Hamming, au moyen d'une première règle de codage et un quatrième code, ayant une deuxième distance de Hamming, au moyen d'une deuxième règle de codage à partir des données reçues, comparant le premier code au troisième code et le deuxième code au quatrième code et exploitant le résultat de la comparaison du premier code au troisième code et du deuxième code au quatrième code, le récepteur (2) comportant comme moyen de codage des données au moins un troisième registre à décalage à boucle fermée linéaire (10) et un quatrième registre à décalage à boucle fermée linéaire (11), le troisième registre à décalage à boucle fermée linéaire (10) et le quatrième registre à décalage à boucle fermée linéaire (11) utilisant des règles de codage différentes, la règle de codage respective étant réalisée par une rétroaction linéaire correspondante des registres à décalage respectifs (10, 11) et le troisième registre à décalage à boucle fermée linéaire (10) utilisant une première règle de codage et le quatrième registre à décalage à boucle fermée linéaire (11) utilisant une deuxième règle de codage et, pour déterminer la distance de Hamming des règles de codage et/ou des codes générés, la totalité de toutes les erreurs possibles non reconnues lors de la transmission de données respective étant formée à partir d'un nombre de blocs de données linéairement indépendants, le nombre des blocs de données linéairement indépendants correspondant respectivement au nombre des bits de données utiles.

17. Récepteur selon la revendication 16, **caractérisé en ce qu'**un code généré est constitué de bits de signature.

**18.** Récepteur selon l'une des revendications 16 ou 17, **caractérisé en ce que** les données reçues sont constituées de bits de données utiles et/ou de bits de signature.

**19.** Récepteur selon l'une des revendications 16 à 18, **caractérisé en ce que** le système est destiné à réduire de façon définie la probabilité d'erreurs résiduelles.

**20.** Récepteur selon l'une des revendications précédentes, **caractérisé en ce que** le code généré par la deuxième règle de codage a une distance de Hamming qui est supérieure ou inférieure à celle du code généré par la première règle de codage.

**21.** Récepteur selon l'une des revendications précédentes, **caractérisé en ce que** le code généré par la deuxième règle de codage a un nombre de bits de signature qui est supérieur ou inférieur à celui du code généré par la première règle de codage.

**22.** Récepteur selon l'une des revendications précédentes, **caractérisé en ce que** la distance de Hamming du code généré des première et deuxième règles de codage utilisées en combinaison est supérieure à la plus grande des deux distances de Hamming du code généré par la première ou deuxième règle de codage lorsque le nombre des bits de données utiles à transmettre est inférieur ou égal au plus petit nombre des bits de signature associés.

**23.** Système (15), notamment système d'automatisation, permettant de réduire d'une façon définie la probabilité d'erreurs résiduelles lors de la transmission de données, la probabilité d'erreurs résiduelles R(p) étant définie par :

$$R(p) = \sum_{m=d}^{N} H(m) \times p^m \times q^{N-m}$$

où

m est le nombre de bits erronés reçus,

d est la distance de Hamming d'un code utilisé,

N est la longueur binaire du bloc de données transmis,

H(m) est la fréquence des erreurs de m bits, que le code ne peut pas reconnaître,

p est le taux d'erreur de bit pour une transmission de données et

q est la probabilité de réception d'un bit non erroné,

le système (15) comportant au moins un émetteur (1) présentant les caractéristiques selon l'une des revendications 9 à 15 et au moins un récepteur (2) présentant les caractéristiques selon l'une des revendications 16 à 22, l'émetteur (1) et le récepteur (2) étant reliés entre eux au moyen d'une liaison de transmission (3) et les données étant transmises de l'émetteur (1) au récepteur (2) ou inversement par la liaison de transmission, la génération des codes étant effectuée au moyen de règles de codage et, pour déterminer la distance de Hamming des règles de codage et/ou des codes générés, la totalité de toutes les erreurs possibles non reconnues lors de la transmission de données respective étant formée à partir d'un nombre de blocs de données linéairement indépendants, le nombre des blocs de données linéairement indépendants correspondant respectivement au nombre des bits de données utiles.

# FIG 1

FIG 2

Erzeugung und Speicherung
erster Signatur der Länge n1 und
zweiter Signatur der Länge n2
aus k Nutzdaten beim Sender — 20

Senden der k Nutzdaten und der beiden Signaturen
vom Sender an und Speicherung beim Empfänger — 21

Erzeugung und Speicherung
dritter Signatur der Länge n1 und
vierter Signatur der Länge n2
aus k Nutzdaten beim Empfänger — 22

Vergleich der ersten Signatur mit der dritten Signatur
und der zweiten Signatur mit der vierten Signatur
beim Empfänger — 23

24

Übereinstimmung der jeweiligen
Signaturen

ja

nein

26 — Empfangenen
Datensatz verwerfen

Weiterverarbeitung der k
Nutzdaten beim Empfänger

25

27 — Wiederholung des
Sendevorgangs anfordern

24

```
┌─────────────────────────────────────────────────────────────┐  ╭─30
│   Erzeugung und Speicherung erster Signatur der Länge n1       │
│   und zweiter Signatur der Länge n2 aus k Nutzdaten beim Sender │
└─────────────────────────────────────────────────────────────┘
                            │
                            ▼                                      ╭─31
┌─────────────────────────────────────────────────────────────┐
│   Senden der k Nutzdaten und der beiden Signaturen             │
│   vom Sender an und Speicherung beim Empfänger                 │
└─────────────────────────────────────────────────────────────┘
            │                                    │
            ▼                  ╭─32               ▼                ╭─33
┌─────────────────────────┐        ┌─────────────────────────────┐
│  Zuführung und Taktweises │        │  Senden der zweiten Signatur │
│  hinein-schieben der k    │        │  vom Sender an und           │
│  Nutzdaten in das dritte  │        │  Speicherung beim Empfänger  │
│  und vierte LSFR beim     │        └─────────────────────────────┘
│  Empfänger                │
└─────────────────────────┘
            │
            ▼                  ╭─34
┌─────────────────────────┐
│  nach k Takten: Aufhalten │
│  des vierten LSFR und     │
│  Hineinschieben der ersten │
│  Signatur der Länge n1    │
│  in das dritte LSFR       │
└─────────────────────────┘
            │
            ▼
35╮                                                    FIG 3
┌─────────────────────────┐
│  nach k Takten: Aufhalten │
│  des dritten LSFR und     │
│  Hineinschieben der zweiten │
│  Signatur der Länge n2    │
│  in das vierte LSFR       │
└─────────────────────────┘
            │
            ▼
36╮       ◇──────────────────◇         ja
         ╱ Nach n2 Takten:    ╲─────────────┐
        ◇  Inhalt des dritten   ◇           │
         ╲ und vierten LSFR =0 ╱            │
          ◇──────────────────◇             │
            │ nein                           │
            ▼                                ▼              ╭─37
38╮ ┌─────────────────────┐    ┌─────────────────────────────┐
   │  Empfangenen          │    │  Weiterverarbeitung der k    │
   │  Datensatz verwerfen   │    │  Nutzdaten beim Empfänger     │
   └─────────────────────┘    └─────────────────────────────┘
            │
            ▼
39╮ ┌─────────────────────┐
   │  Wiederholung des      │
   │  Sendevorgangs anfordern │
   └─────────────────────┘
```

# FIG 4

~40

| Hamming-Distanz HD | 2 | 3 | 4 | 5 | 6 | 7 |
|---|---|---|---|---|---|---|
| Häufigkeit von HD | 7 | 14 | 221 | 262 | 508 | 12 |
| Digitaler Wert von 12 Rück-kopplungen | 916 | 914 | 872 | 849 | 570 | 555 |
| mit HD=7 | 440 | 369 | 295 | 167 | 118 | 91 |

# FIG 5

~50

| Anzahl der Bits im Tupel | Anzahl der Bitfehler | | | | | | | | Anzahl der gesamten Fehlerfälle |
|---|---|---|---|---|---|---|---|---|---|
| m | 4 | 6 | 8 | 10 | 12 | 14 | 16 | 18 | $2^{11-m}$ |
| 3 | 0 | 8 | 42 | 112 | 68 | 24 | 2 | 0 | 256 |
| 4 | 0 | 1 | 14 | 54 | 40 | 17 | 2 | 0 | 128 |
| 5 | 0 | 0 | 3 | 25 | 23 | 11 | 2 | 0 | 64 |
| 6 | 0 | 0 | 1 | 9 | 13 | 7 | 2 | 0 | 32 |
| 7 | 0 | 0 | 0 | 3 | 7 | 5 | 1 | 0 | 16 |
| 8 | 0 | 0 | 0 | 1 | 3 | 3 | 1 | 0 | 8 |
| 9 | 0 | 0 | 0 | 0 | 1 | 2 | 1 | 0 | 4 |
| 10 | 0 | 0 | 0 | 0 | 0 | 1 | 1 | 0 | 2 |
| 11 | 0 | 0 | 0 | 0 | 0 | 0 | 1 | 0 | 1 |